(19) Europäisches Patentamt
European Patent Office
Office européen des brevets

(11) EP 0 458 502 B1

(12) **EUROPEAN PATENT SPECIFICATION**

(45) Date of publication and mention of the grant of the patent:
**18.06.2003 Bulletin 2003/25**

(51) Int Cl.^7: **C08G 59/40**, C08G 59/42

(21) Application number: **91304277.6**

(22) Date of filing: **13.05.1991**

(54) **Latent catalysts, cure-inhibited epoxy resin compositions and laminates prepared therefrom**

Latente Katalysatoren, Härtungsinhibierte Epoxyharzzusammensetzungen und daraus hergestellte Laminate

Catalyseurs latents,compositions de résines époxy à durcissement inhibé et stratifié ainsi obtenues

(84) Designated Contracting States:
**AT BE CH DE DK ES FR GB IT LI NL SE**

(30) Priority: **21.05.1990 US 526488**
**21.05.1990 US 526487**

(43) Date of publication of application:
**27.11.1991 Bulletin 1991/48**

(73) Proprietor: **Dow Global Technologies Inc.**
**Midland, Michigan 48674 (US)**

(72) Inventors:
- **Bertram, James L.**
  **Lake Jackson, Texas 77566 (US)**
- **Hotz, Charlie Z.**
  **Walnut Creek, California 94598 (US)**
- **Walker, Louis L.**
  **Clute, Texas 77531 (US)**
- **Gan, Joseph**
  **F-67100 Strasbourg (FR)**

(74) Representative: **Raynor, John et al**
**W.H. Beck, Greener & Co**
**7 Stone Buildings**
**Lincoln's Inn**
**London WC2A 3SZ (GB)**

(56) References cited:
**WO-A-86/00627**
**US-A- 4 001 156**
**US-A- 4 668 758**

Remarks:
The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

This invention relates to epoxy resin compositions containing compounds which inhibit the cure of the epoxy resins at lower temperatures and to latent catalyst compositions for curing epoxy resins. The invention further relates to compositions useful for curing epoxy resins which comprise curing agents for the epoxy resins and the inhibitor described above. The invention further relates to coatings prepared from such inhibited resin compositions, and to materials coated with or encapsulated by such inhibited resin compositions. The invention further relates to laminates, prepregs, encapsulated materials and composites prepared from such inhibited resin compositions.

Epoxy resins are used in a variety of applications, such as powder coatings, in encapsulation of electrical components, in composites, in solution coatings, in prepregs and in laminates. In many of these uses, it is desirable to partially cure the epoxy resin in a controllable manner, such that at a later time, when desired, the epoxy resin can be fully cured. In many uses it is desirable to contact a curing agent for an epoxy resin with an epoxy resin in the presence of a catalyst for the reaction and have the composition remain stable, that is uncured for a period of time. At present it is quite difficult to control the curing of an epoxy resin and retain the stability of a composition comprising an epoxy resin, a curing agent and catalyst for the reaction of the epoxy resin with the curing agent.

In some uses the epoxy resin, curing agent, and catalyst are contacted in solution and then applied as a coating on a substrate. In such uses, in order to achieve optimal properties in the cured epoxy resin, the solvent or solvents must be removed. Often it is desirable to remove these solvents before significant curing takes place, otherwise the solvent may be entrapped in the cured epoxy resin, thereby adversely affecting the final properties of the cured resin. Often, the solvent is removed by exposing the coated article to elevated temperatures. At such temperatures the epoxy resin may have a tendency to begin to cure and entrap the solvent, thereby adversely affecting the final properties.

Cured and partially cured epoxy resins are used in laminates. A common process used in preparing glass laminates involves passing a glass cloth to be coated with an epoxy resin composition through a bath containing the resin, a curing agent for the resin and a catalyst for the curing reaction. Generally the bath contains one or more organic solvents in which the various components are dissolved or dispersed, with a solids contents of from 45 to 90 percent. The glass is resident in the bath for time sufficient to coat it with a mixture of the resin, curing agent and catalyst for the curing reaction. Thereafter the coated glass is passed through a heated zone to remove remaining solvent by evaporation. Generally, this zone is at a temperature of between 120°C and 200°C. The residence time in this zone is sufficient to allow the solvents to be completely volatilized away. Thereafter the glass cloth, coated with the resin, curing agent and catalyst from which the solvents have been removed, may be partially cured by exposing it to temperatures at which curing occurs. Such a product is referred to as a prepreg. The prepregs may then be stacked or formed into a shape and exposed to conditions under which the curing agent and resin completes the cure. In general, this involves contacting the various components of a laminate at elevated temperatures under pressure, for a period of time sufficient for the epoxy resin to further cure. Usually the pressure is provided by some kind of a press. Once the laminate is removed from the press it may, optionally, be exposed to elevated temperature for a period of time to complete the curing reaction. In this curing process the resin coating on the glass cloth flows and mixes with the coating on adjacent glass clothes thereby resulting in a fusing of the glass layers together, via a matrix of the cured epoxy resin.

High glass transition temperatures are desirable for many uses, therefore methods of increasing the glass transition temperatures are desired. It is further desired to significantly decrease the time necessary to achieve complete cure. Prepreg producers and laminators desire a composition which facilitates faster processing. This allows the more efficient utilization of processing equipment. In order to facilitate faster processing the coated substrates must be exposed to higher temperatures or the epoxy resin compositions must contain higher levels of catalysts. Unfortunately, both solutions result in less control over the curing reaction and solvent can be trapped in the final product thereby affecting the ultimate properties.

One process commonly employed is referred to as continuous pressing. In this process the prepregs are contacted at much higher temperatures than in conventional laminate processing for shorter periods, e.g. at temperatures around 210°C for 2 to 4 minutes. It is very difficult to achieve complete cure under such conditions. One potential solution to this is to add a larger amount of catalyst or accelerator to the epoxy resin. Unfortunately if additional catalyst is added in the coating bath, then the ability to remove the solvent without significant curing of the epoxy resin, or to controllably partially cure the epoxy resin, is significantly reduced.

Several references disclose curable epoxy resin compositions which include as a catalyst a salt of fluoroboric acid, (tetrafluoroborate, fluoboric acid, and hydrofluoroboric acid), and fluoborates. GB 963,058 (published July 8, 1964) discloses amine salts of hydrofluorboric acid. U.S. Patent No. 4,438,254 (issued March 20, 1984 to Doorakian et al.) discloses phosphonium salts of tetrafluoroborate. U.S. Patent No. 3,048,552 (issued August 7, 1962 to Fang) discloses a quaternary ammonium fluoborate salt. "Proposed Mechanism for the Curing of Epoxy Resins with Amine-Lewis Acid Complexes or Salts" by James J. Harris and Samuel C. Temin, J. Ap. Pol. Sc., Vol. 10, pp. 523-534 (1966) discloses fluoborate salts of aliphatic and aromatic amines and pyridine. Several patents disclose that onium salts of

tetrafluoroborate (flouroboric acid) are useful as accelerators in epoxy resin curing reactions. Smith U.S. Patent No. 4,318,766, Martin U.S. Patent No. 4,322,456 Whiteside Jr et al U.S. Patent No. 4,410,596, Corley U.S. Patent No. 4,544,732, Corley U.S. Patent No. 4,554,342, Corley U.S. Patent No. 4,581,436, Goel et al U.S. Patent No. 4,766,196, and Perry, Canada 893,191.

Japanese 58/138729 (published August 17, 1983) discloses thermosetting molding compositions whose essential components are a resin component consisting of (a) epoxy resin, (b) an alkenylphenol polymer, and (c) a latent curing accelerator together with (d) fibers and/or granular fillers, wherein the alkenylphenol polymer is dispersed and mixed as a powder in the epoxy resin along with the fillers. It discloses as the latent curing accelerator tetrasubstituted boron salts of ammonium compounds, phosphonium compounds, arsonium compounds, imidazolium compounds, pyridinium compounds, or morpholinium compounds. Only tetraphenyl or tetrabutyl borate salts are believed to be disclosed.

U.S. Patent No. 3,947,395 (issued March 30, 1976 to Ogata et al.) discloses surface coating compositions consisting essentially of (a) at least one of coal tar and asphalt, (b) an epoxy resin and (c) at least one of tetrasubstituted boron salts of onium ions and tetrasubstituted boron salts of imidazolium ions, which are suitable for coating the surface of concrete, asphalt or metal. The patent is believed to only disclose tetra phenyl or tetra(substituted phenyl) boron salts.

Markert et al, U.S. Patent No. 4,631,306 discloses a method of manufacture an insulating component made from a mixture of polyepoxide and a polyisocyanate. Disclosed is the use of latent catalysts which are the addition complexes of boron trihalogenides with tertiary amines and imidazoles.

Klarquist et al U.S. Patent No. 3,738,862 discloses a process for preparing epoxy resin laminates and accelerator compositions useful in such a process. Suitable accelerators (catalysts) disclosed include the stannous salts of monocarboxylic acids, lithium benzoate, certain heterocyclic compounds such as the imidazole and benzimidazole compounds and salts thereof, tertiary amine borates, and tertiary amines among others. Suitable tertiary amine borates can be prepared by reacting at room temperature a tertiary amine with a borate such as, for example, methyl borate or triethyl borate. Suitable tertiary amine borates include, among others, trimethylamine borate, triethylamine borate, triethanolamine borate, triisopropanolamine borate, benzyl-dimethylamine borate, alphamethylbenzyl-dimethylamine borate, dimethylamino-methyl phenol borate, and tridimethyl aminomethyl phenol borate. Particularly preferred is triethanolamine borate.

Bertram et al U.S. Patent No. 4,725,652 discloses latent catalysts for epoxy reactions prepared by reacting a tetrasubstituted onium compound such as tetrabutylphosphonium acetate acetic acid complex or an amine compound with an acid having a weak-nucleophilic anion such as fluoroboric acid. These catalysts provide stable latent catalysts for epoxy resins for advancement or curing reactions.

Copending applications serial no. 07/274,250 filed November 18, 1988, serial no. 07/274,227 filed November 18, 1988 and serial no. 07/274,264 filed November 18, 1988 disclose catalysts which render a mixture of an epoxy resin and an aromatic hydroxyl- -containing compound storage stable; however, these catalysts which are formed by contacting an imidazole compound or an onium compound or an adduct of an amine and an acid having a strong nucleophilic anion with an acid having a weak nucleophilic anion such as fluoboric acid result in compositions having a relatively long induction time at elevated curing temperatures.

JP-A-56-72045 and JP-A-5978229 disclose epoxy resin compositions containing boric acid as a corrosion inhibitor to passivate a metal layer. In these references, the boric acid reacts, with the metal, and is thus rat available as a cure inhibitor.

The above-described latent catalyst systems function so well that extreme conditions are required to initiate the curing reaction. What is needed are cure inhibiting compositions which do not require extreme conditions to reverse their effect, specifically latent catalyst systems which can accelerate curing of epoxy resin compositions under reasonable conditions.

What is also needed is an epoxy resin composition that does not undergo significant cure at temperatures at which solvents may be removed, and particularly an epoxy resin that can be controllably B-staged or partially advanced. What is further needed is an epoxy resin composition which allows the use of higher concentrations of curing catalysts or accelerators, which is stable at temperatures at which solvent is removed, and which allows controllable B-staging or partial advancement. What is further needed is an epoxy resin composition which when coated on a substrate can be processed quickly without negatively affecting the ultimate properties.

Frequently, for many products prepared using epoxy resins and cured epoxy resins several different entities may perform different parts of the manufacturing process. For example, one entity may make the resin, a second entity may make the resin formulations used to impregnate the reinforcing material, and a third may make a prepreg, or other article to be used. While a forth would make the final product such as a laminate or printed circuit board. Frequently the entity producing the prepreg or laminate has no expertise or desire to make the formulation. Therefore, it is desirable that a formulator be able to make a composition useful in coating the materials to be laminated. If the epoxy resin curing agent and catalyst are preformulated however, the formulation may not have significant long-term storage stability. Under such circumstances the formulation may undergo curing and therefore not be useful to the prepreg or

laminate manufacturer. It would be desirable therefore to provide an epoxy resin composition containing a curing agent and accelerator for the cure which has significant stability at ambient temperatures for several weeks.

Further, different end users have different processing equipment and methods for applying the epoxy resin coatings. Such differences require different properties in the resin. One property is the gel time of the resin. Different end users desire different gel times. It is desirable to have methods for adjusting controllably the gel time of the resins.

In summary, the invention is related to the discovery of a class of compounds which inhibits the reaction of a polyepoxide with a curing agent in the presence of a catalyst for the curing reaction at low temperatures. More particularly, the invention relates to an epoxy resin composition comprising

a) a polyepoxide,
b) a solvent, and
c) a cure inhibitor comprising boric acid or maleic acid, or a mixture of boric acid with at least one acid having a weak nucleophilic anion provided that when the inhibitor is boric acid, it is present in an amount of at least 0.013 mole of inhibitor per epoxide equivalent of epoxy resin. In another embodiment, the invention relates to the use as a cure inhibitor for an epoxy resin composition of boric acid or maleic acid in an amount such as to inhibit curing of the epoxy resin during solvent removal.

In another embodiment the invention is a latent catalyst system adapted for curing a polyepoxide at elevated temperatures, the catalyst resulting from contacting

I) a catalyst for the cure of a polyepoxide compound comprising an amine, heterocyclic nitrogen, phosphine, sulfide, ammonium, phosphonium, sulfonium, or arsonium containing compound or a mixture thereof; with

II) boric acid, or a mixture of boric acid with at least one acid having a weak nucleophilic anion or maleic acid.

In still another embodiment, the invention relates to a process for coating an article with an epoxy resin composition comprising

A. contacting an article with a composition of this invention;

B. optionally, passing the coated article through a heated zone at a temperature sufficient to cause any solvent present to evaporate but below the temperature at which the polyepoxide undergoes significant curing; and

C. optionally, exposing the coated article to conditions such that the polyepoxide undergoes at least partial curing.

The invention has several advantages. A composition comprising a polyepoxide, a curing agent, a catalyst, and inhibitor can be exposed to temperatures at which any solvent present is removed by evaporation without significant curing of the epoxy resin. Furthermore in the presence of the inhibitor, the concentration of catalyst present may be significantly higher without resulting in cure of the epoxy resin composition during a solvent removal process. A higher crosslink density may be achieved by using a larger concentration of catalyst. The final products prepared from these epoxy resin compositions may therefore exhibit a higher glass transition temperature. Those resin compositions which contain a polyepoxide, curing agent, catalyst and inhibitor have a significantly longer shelf life at ambient temperatures. The compositions of this invention may be processed at faster speeds as a higher concentration of accelerator may be used in processing. The compositions may also be processed at high temperatures without adversely affecting the final product properties, for example in the continuous pressing process. Further, by adjusting the level of catalyst, inhibitor, or latent catalyst, the gel time of a resin can be controllably adjusted.

This invention relates to novel resin compositions containing latent catalyst systems, and articles containing such resin compositions or coated with such resin compositions.

The inhibitor and catalyst could be contacted with the polyepoxide separately, or optionally, the inhibitor and catalyst could be contacted prior to contacting with the polyepoxide so as to form a complex, and thereafter the complex could be contacted with the polyepoxide. In this embodiment the inhibitor may optionally be in admixture with at least one acid having a weak nucleophilic anion. This latent catalyst composition can be used in any embodiment described herein where both inhibitor and catalyst are simultaneously present.

In another embodiment, the invention comprises a partially cured reaction product of a polyepoxide, a curing agent, wherein such partial cure occurs in the presence of catalyst for the reaction of the curing agent with a polyepoxide, and a cure inhibitor comprising boric acid or maleic acid, optionally be in admixture with at least one acid having a weak nucleophilic anion. Such partially cured product can thereafter be used in several applications, such as coatings, laminates, composites, encapsulants, by contacting the partially cured product with the appropriate substrate, reinforcing material, or the like, and fully curing the composition. The processes for obtaining such a partially cured product are well-known in the art. In particular, the components are contacted under condition such that the curing agent and polyepoxide undergo partial reaction. In some embodiments the reactive ingredients are partially cured on the surface of a substrate.

The compositions described herein may be found in various forms. In particular the various compositions described may be found in powder form, or alternatively in solution or dispersion. In those embodiments where the various compositions are in solution or dispersion, the various components of the composition may be separately dissolved in a solvent suitable for that component, then the various solutions are combined and intimately mixed. Note the solvents for the various components are preferably chosen such that the solvents are miscible with one another. Intimately mixed as used herein refers to agitating a mixture of solutions which is a relatively homogeneous solution or dispersion. Alternatively, the components may be dissolved or dispersed in the same solvent or dispersant. In those embodiments wherein the compositions are partially cured or advanced, the compositions of this invention may be found in a powder form, solution form, or coated on a particular substrate.

Polyepoxide as used herein refers to a compound containing more than one epoxy moiety. In another embodiment it refers to a mixture of compounds which contains, on average, more than one epoxy moiety per molecule. Polyepoxide as used herein includes partially advanced epoxy resins i.e. the reaction of a polyepoxide and a curing agent, wherein the reaction product has an average at least one unreacted epoxide unit per molecule.

Preferable compounds having an average of more than one epoxide group per molecule which can be employed herein include, epoxy resins such as, for example, the glycidyl ethers of polyhydric phenols, i.e. compounds having an average of more than one aromatic hydroxyl group per molecule such as, for example, dihydroxy phenols, biphenols, bisphenols, halogenated biphenols, halogenated bisphenols, alkylated biphenols alkylated bisphenols, trisphenols, phenol-aldehyde novolac resins, substituted phenol-aldehyde novolac resins, phenol-hydrocarbon resins, substituted phenol-hydrocarbon resins and any combination thereof.

Polyepoxides (polyglycidyl ethers of a polyhydroxy hydrocarbon) are prepared by reacting an epihalohydrin with a polyhydroxy hydrocarbon or a halogenated polyhydroxy hydrocarbon. The preparation of such compounds is well known in the art. See Kirk-Othmer Encyclopaedia of Chemical Technology 3rd Ed. Vol. 9 pp 267-289.

The epihalohydrins correspond to formula 1

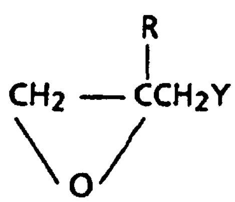

1

wherein Y is a halogen, preferably chloro or bromo, and most preferably chloro; and R is hydrogen or $C_{1-4}$ alkyl, and more preferably methyl.

Polyhydroxy hydrocarbon means herein a compound with a hydrocarbon backbone and on average more than one primary or secondary hydroxy moieties, preferably two or more. Halogenated polyhydroxy hydrocarbon means herein a compound with a hydrocarbon backbone which is substituted with one or more halogens and more than one, preferably two or more, primary or secondary hydroxy moieties. The hydroxyl moieties may be aromatic aliphatic or cycloaliphatic.

Among even more preferred classes of polyhydroxy hydrocarbons and halogenated polyhydroxy hydrocarbons are the dihydroxy phenols; biphenols; bisphenols; halogenated bisphenols; alkylated bisphenols; trisphenols; hydrogenated bisphenols; novolac resins, i.e. the reaction product of phenols, including halogenated and alkylated phenols, and simple aldehydes, preferably formaldehyde and hydroxy benzaldehyde; and polyalkylene glycols.

Preferred polyhydroxy hydrocarbons, and halogenated polyhydroxy hydrocarbons include those corresponding to formulas 2 to 5:

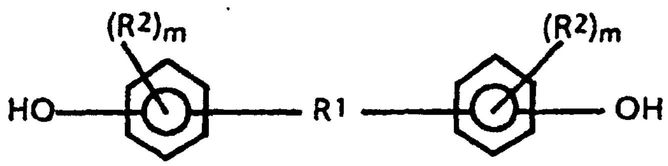

2

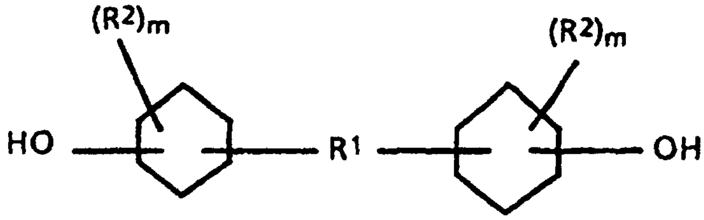

3

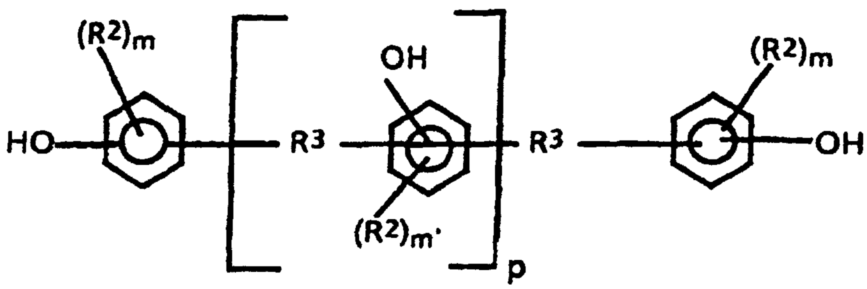

4

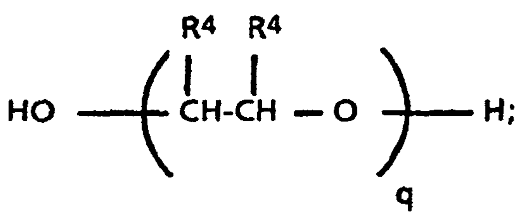

5

wherein:

$R^1$ is separately in each occurrence $C_{1-10}$ alkylene, $C_{1-10}$ haloalkylene, $C_{4-10}$ cycloalkylene, carbonyl, sulfonyl, sulfinyl, oxygen, sulfur, a direct bond or a moiety corresponding to the formula

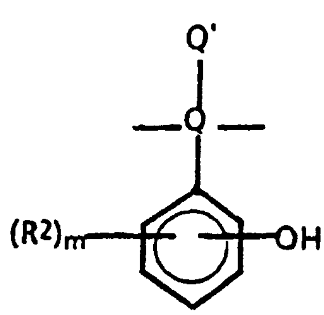

$R^2$ is separately in each occurrence $C_{1-3}$ alkyl or a halogen;

$R^3$ is separately in each occurrence $C_{1-10}$ alkylene or $C_{5-50}$ cycloalkylene;

$R^4$ is separately in each occurrence hydrogen, methyl, halomethyl, or ethyl, with the proviso that only one $R^4$ on an ethylene unit can be methyl, halomethyl or ethyl;

Q is separately in each occurrence a $C_{1-10}$ hydrocarbyl moiety;

Q' is separately in each occurrence hydrogen, cyano, or a $C_{1-14}$ alkyl group;

m is independently in each occurrence an integer of 0 to 4;

m' is separately in each occurrence an integer of from 0 to 3;

p is a positive real number of 0 to 10;

q is a positive real number of 1 to 80.

$R^1$ is preferably $C_{1-3}$ alkylene, $C_{1-3}$ haloalkylene, carbonyl, sulfur, or a direct bond. $R^1$ is more preferably a direct bond, $C_{1-3}$ alkylene, or fluorinated propylene (=$C(CF_3)_2$-). $R^1$ is most preferably propylene. $R^2$ is preferably methyl, bromo or chloro; and most preferably methyl or bromo. $R^3$ is preferably $C_{1-3}$ alkylene or polycyclic moiety corresponding to the formula

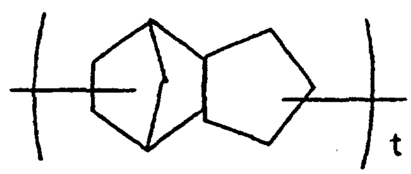

wherein t is an average number between 1 and 6 inclusive, preferably 1 and 3, most preferably 1. Preferably, m' is an integer of 0 to 2. Preferably, m is an integer of 0 to 2. Preferably, p is a positive real number of 0 to 8; and more preferably 0 to 4. Preferably, q is a positive real number between 2 and 40, and more preferably between 2 and 20 and most preferably 5 and 15. P and q represent an average number, as the compounds to which they refer are generally found as a mixture of compounds with a distribution of the units to which p and q refer. Cycloalkylene as used herein refers to monocyclic and polycyclic hydrocarbon moieties.

The most preferred class of polyhydroxy hydrocarbons are the dihydroxy phenols. Preferable dihydroxy phenols include those which contain substituents that are non-reactive with the phenolic groups. Illustrative of such phenols are 2,2-bis(3,5-dibromo-4-hydroxyphenyl) propane; 2,2-bis(4-hydroxyphenyl) propane; 2,2-bis(3,5-dichloro-4-hydroxyphenyl) propane; bis (4-hydroxyphenyl) methane; 1,1-bis(4-hydroxyphenyl)-1-phenyl ethane; 1,1'-bis(2,6-dibromo-3,5-dimethyl-4 hydroxy phenyl) propane; bis (4-hydroxyphenyl) sulfone; bis (4-hydroxyphenyl) sulfide; resorcinol and hydroquinone. The preferred dihydroxy phenolic compound is 2,2-bis(4-hydroxyphenyl) propane (bisphenol A) and 2,2-bis(4-hydroxy-3,5-dibromophenyl) propane.

As used herein haloalkyl refers to a compound with a carbon chain and one or more of the hydrogens replaced with a halogen. Haloalkyl also means compounds wherein all of the hydrogen atoms have been replaced by halogen atoms. Alkylene as used herein refers to a divalent alkyl moiety.

The term hydrocarbyl as employed herein means any aliphatic, cycloaliphatic, aromatic, aryl substituted aliphatic or cycloaliphatic, or aliphatic or cycloaliphatic substituted aromatic groups. The aliphatic groups can be saturated or unsaturated. Likewise, the term hydrocarbyloxy means a hydrocarbyl group having an oxygen linkage between it and the carbon atom to which it is attached.

The polyepoxides preferably correspond to one of formulas 6 to 9.

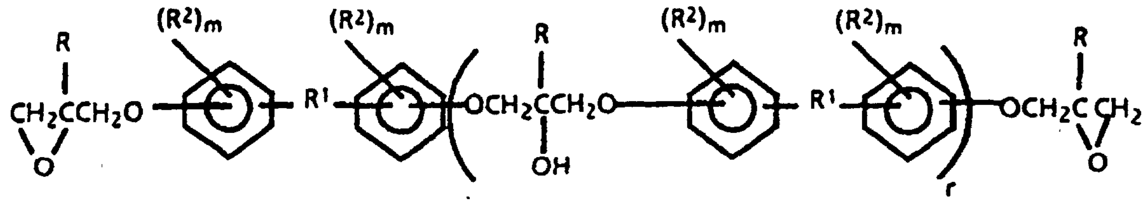

6

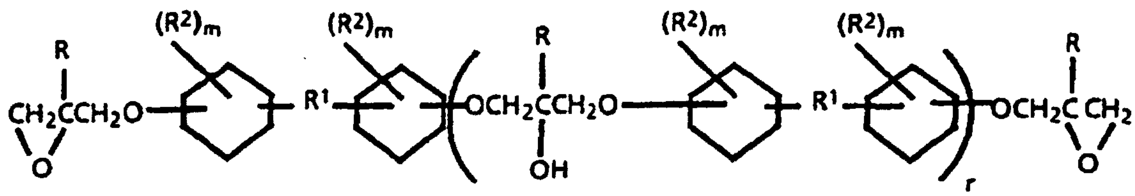

7

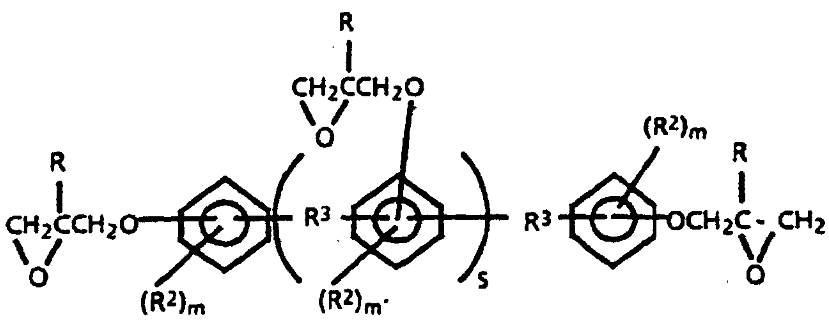

8

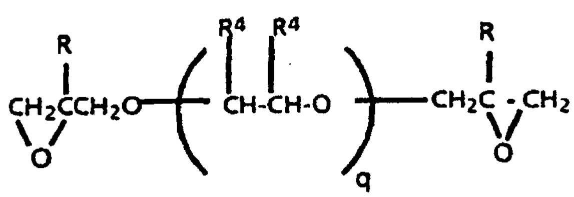

9

wherein $R^1$, $R^2$, $R^3$, $R^4$, m, m' and q are as defined previously; r is a positive real number of 0 to 40; and s is a positive real number of 0 to 10. Preferably, r is a positive real number of 0 to 10, and most preferably 1 to 5. Preferably, s is a positive real number of 0 to 8; and most preferably 1 to 4. All of the variables referred to herein as positive real numbers, i.e. r and s, are average numbers as the compounds referred to contain a distribution of units.

Preferable epoxide compounds are the glycidyl ethers of compounds having an average of more than one aliphatic hydroxyl group per molecule such as, for example, aliphatic diols, polyether diols, polyether triols, polyether tetrols and any combination thereof. Also preferable are the alkylene oxide adducts of compounds containing an average of more than one aromatic hydroxyl group per molecule such as, for example, the ethylene oxide, propylene oxide, or butylene oxide adducts of dihydroxy phenols, biphenols, bisphenols, halogenated bisphenols, alkylated bisphenols, trisphenols, phenol-aldehyde novolac resins, halogenated phenol-aldehyde novolac resins, alkylated phenol-aldehyde novolac resins, hydrocarbon-phenol resins, hydrocarbon-halogenated phenol resins, or hydrocarbon-alkylated phenol resins,or any combination thereof and the like.

Preferable epoxy resins include, for example, the diglycidyl ethers of resorcinol, catechol, hydroquinone, biphenol, bisphenol A, bisphenol AP (1,1-bis(4-hydroxylphenyl)-1-phenyl ethane), bisphenol F, bisphenol K, tetrabromobisphenol A, phenol-formaldehyde novolac resins, alkyl substituted phenol-formaldehyde resins, phenol-hydroxybenzaldehyde resins, cresol-hydroxybenzaldehyde resins, dicyclopentadiene-phenol resins, dicyclopentadiene-substituted phenol resins tetramethylbiphenol, tetramethyl-tetrabromobiphenol, tetramethyltribromobiphenol, tetrachlorobisphenol A and any combination thereof.

In one embodiment polyepoxides refers to an advanced epoxy resin which is the reaction product of one or more polyepoxides, as described previously, with one or more polyhydroxy hydrocarbons or a halogenated derivative thereof. Such polyhydroxy hydrocarbons have been described previously. Alternatively, a polyepoxide can be reacted with a carboxyl substituted hydrocarbon. A carboxyl substituted hydrocarbon is a compound with a hydrocarbon backbone and one or more carboxyl moieties, preferably more than one, and most preferably two. Preferably such compounds correspond to formula 10;

$$R^5\ (COOH)_u \qquad 10$$

wherein $R^5$ is $C_{1-40}$ hydrocarbyl moiety optionally containing oxygen along the backbone, and u is an integer of one or greater. $R^5$ is preferably a $C_{1-40}$ straight or branched chain alkane or alkene, optionally containing oxygen. Preferably u is 1 to 4, and most preferably 2. Fatty acids and fatty acid dimers are among the useful carboxylic acid substituted hydrocarbons. Included in the fatty acids are caproic acid, caprylic acid, capric acid, octanoic acid, versatic acid, decanoic acid, lauric acid, myristic acid, palmitic acid, stearic acid, palmitoleic acid, oleic acid, linoleic acid, linolenic acid, erucic acid, pentadecanoic acid, margaric acid, arachidic acid, and dimers thereof.

In one preferred embodiment a one or more polyhydroxy hydrocarbons or halogenated derivatives thereof and one or more carboxyl substituted hydrocarbons are reacted with the polyglycidyl ether of a polyhydroxy compound or halogenated derivative thereof. Procedures for performing such a reaction are well known in the art. See "The Handbook of Epoxy Resins" by H. Lee and K. Neville (1967) McGraw Hill, New York, and U.S. Patent Nos. 2,633,458; 3,477,990; 3,821,243; 3,907,719, 3,975,397; and 4,071,477. Optionally, a small amount of a monohydroxy substituted hydrocarbon can be included in the reaction mixture.

In another embodiment, the polyepoxide is the reaction product of a polyepoxide and a compound containing more than one isocyanate moiety, a polyisocyanate. Preferably the polyepoxide is an epoxy-terminated polyoxazolidone having from 5 to 30, preferably 5 to 20, most preferably 10 to 20 weight percent isocyanate content and having from 50 to 100 percent of the original isocyanate groups converted to oxazolidone rings and from 0 to 50 percent of the original isocyanate groups converted to isocyanurate rings whenever prepared according to the process described herein.

Epoxy-terminated polyoxazolidone (isocyanate modified epoxy resin) are preferably prepared by the process which comprises reacting a polyepoxide compound with a polyisocyanate compound in the presence of a catalyst for the reaction of the epoxy and isocyanate groups at an elevated temperature. Preferably the process involves first adding (1) from 5 to 30, preferably 5 to 20, most preferably from 10 to 20, weight percent of the polyisocyanate compound within a period of time of from 3 to 90, preferably 15 to 60, most preferably 20 to 45, minutes to (2) a mixture comprising (a) from 70 to 95, preferably 80 to 95, most preferably 80 to 90, weight percent of the polyepoxide compound and (b) from 0.01 to 2, preferably 0.02 to 1, most preferably 0.02 to 0.1, weight percent of the catalyst, said weight percentages being based on the combined weight of the polyepoxide compound and polyisocyanate compound. The mixture is thereafter heated to a temperature of from 110°C to 200°C, preferably 120°C to 180°C, most preferably 140°C to 160°C, for a period of time from 5 to 180, preferably 30 to 120, most preferably 60 to 90, minutes. The conversion of isocyanate groups to the oxazolidone and isocyanurate rings is controlled in any of the following manner:

(i) by increasing the reaction temperature at a given amount of the catalyst and a given amount of the polyisocyanate compound used when higher conversion to oxazolidone rings is desired; or

(ii) by increasing the amount of the catalyst at a given reaction temperature and a given amount of the polyisocyanate compound used when higher conversion to oxazolidone rings is desired; or

(iii) by increasing the amount of the polyisocyanate used at a given amount of the catalyst and a given reaction temperature when higher conversion to isocyanurate rings is desired; or

(iv) by increasing the rate of addition of the polyisocyanate compound at a given reaction temperature, given amount of the catalyst and given amounts of the polyepoxide and polyisocyanate compounds when higher conversion to isocyanurate rings is desired.

The polyepoxides useful for this embodiment are described hereinbefore. The polyisocyanate compounds useful are represented by formula 11:

$$(O=C=N)_v\text{-}R^6 \qquad 11$$

wherein $R^6$ is substituted or unsubstituted aliphatic, aromatic or heterocyclic polyvalent group and v has an average value of greater than 1 to less than 5, preferably from 1.5 to 4, most preferably from 2 to 3. Examples of preferable polyisocyanates include 4,4'-methylene bis(phenylisocyanate) (MDI) and isomers thereof, higher functional homologs of MDI (commonly designated as "polymeric MDI"), toluene diisocyanate (TDI) such as 2,4-toluene diisocyanate and 2,6-toluene diisocyanate, m-xylylene diisocyanate, hexamethylene diisocyanate (HMDI) and isophoronediisocyanate. Mixtures of any two or more polyisocyanates can also be used in the practice of the present invention. Other preferable polyisocyanate compounds are described in U.S. Patent Nos. 3,313,747; 4,066,628 and 4,742,146.

More preferred polyisocyanate compounds are 4,4'-methylene bis(phenylisocyanate) (MDI) and isomers thereof, polymeric MDI and toluene diisocyanate (TDI). The most preferred polyisocyanate compounds are 4,4'-methylene bis(phenylisocyanate), isomers thereof and polymeric MDI.

A suitable catalyst is employed to facilitate reaction of the polyepoxide compound with the polyisocyanate compound. Examples of useful catalysts include zinc carboxylate, organozinc chelate compound, trialkyl aluminum, quaternary phosphonium and ammonium salts, tertiary amines and imidazole compounds. The preferred catalysts are imidazole compounds. Particularly, preferred catalysts are 2-phenyl imidazole 2-methyl imidazole, 1-methyl imidazole, 2-ethyl-4-methyl imidazole and 4,4'-methylene-bis(2-ethyl-4-methyl imidazole). The catalyst is generally employed in an amount of from 0.01 to 2; preferably 0.02 to 1, most preferably 0.02 to 0.1, weight percent based on the combined weight of the polyepoxide compound and polyisocyanate compound used. The polyisocyanate compound is employed in an amount of from 5 to 30, preferably 5 to 20, most preferably 10 to 20, weight percent, the weight percent being based on the combined weight of the polyepoxide and polyisocyanate reactants. The polyepoxide compound is employed in an amount of from 70 to 95, preferably 80 to 95, most preferably 80 to 90, weight percent, the weight percent being based on the combined weight of the polyepoxide and polyisocyanate reactants.

Preferably the catalyst is added to the reaction vessel containing the polyepoxide prior to the start of the addition of polyisocyanate compound. The catalyst can be dissolved in a suitable solvent prior to the addition to the polyepoxide to improve homogenization if desired. The temperature at which the catalyst is added is not critical. In general the catalyst is added at a temperature lower than the reaction temperature. The temperature is then raised and the reaction temperature maintained while the controlled addition of the polyisocyanate to the mixture of the catalyst and the polyepoxide is started. The polyisocyanate is added to the reaction vessel within a period of time of from 3 to 90, preferably 15 to 60, most preferably 20 to 45, minutes while maintaining the reaction temperature. The reaction temperature is maintained after the complete addition of the polyisocyanate for a period of time of from 5 to 180, preferably 15 to 120, most preferably 30 to 90 minutes. In general, the reaction of the polyepoxide compound and the polyisocyanate compound is conducted neat, i.e., in the absence of a solvent or other liquid reaction diluent.

Curing agents useful in this invention are those compounds known to the skilled artisan to react with polyepoxides or advanced epoxy resins to form hardened final products. Included among such useful curing agents are materials which are acidic or alkaline.

Examples of preferable curing agents include among others, aromatic polyhydroxy containing compounds as described hereinbefore. The polybasic acids and their anhydrides, such as, for example, the di-, tri-, and higher carboxylic acids as oxalic acid, phthalic acid, terphtalic acid, succinic acid, alkyl and alkenyl-substituted succinic acids, tartaric acid, and particularly the polymerized unsaturated acids, such as for example those containing at least 10 carbon atoms, and preferably more than 14 carbon atoms, as for instance dodecenedioic acid, 10,12-eicosadienedioic acid, and anhydrides such as phthalic anhydride, succinic anhydride, maleic anhydride, nadic anhydride (endo-cis-bicyclo-(2,21)-5 heptene 2,3 dicarboxylic anhydride), nadic methyl anhydride (methyl bicyclo (2.21) heptene 2,3 dicarboxylic anhydride isomers), pyromellitic anhydride and trimellitic anhydride. Other types of acids that are useful are those containing sulfur, nitrogen, phosphorus or halogens; chloridic acid, benzene phosphonic, sulfonyl dipropionic acid bis(4-carboxyphenyl)amide.

Other preferred curing agents include the amino-containing compounds, such as, for example, diethylene triamine, triethylene tetramine, dicyandiamide, benzoguanimine, melamine, pyridine, cyclohexylamine, benzyldimethylamine, benzylamine, diethylaniline, triethanolamine, piperidine, tetramethylpiperamine, N,N-dibutyl-1,3-propane diamine, N,N-diethyl-1,3-propane diamine, 1,2-diamino-2-methylpropane. 2,3-diamino-2-methylbutane, 2,3-diamino-2-methylpentane, 2,4-diamino-2,6-dimethyloctane, dibutylamine, dioctylamine, dinonylamine, distearylamide, diallylamine, dicyclohexylamine, methylethylamine, ethylcyclohexylamine, pyrrolidine, 2-methylpyrrolidine, tetrahydropyridine, 2-methylpiperidine, 2,6-dimethylpiperidine, diaminopyridine and meta-phenylene diamine, and soluble adducts

of amines and polyepoxides and their salts, such as described in U.S. Patent No. 2,651,589 and U.S. Patent No. 2,640,037. Still other examples include the acetone soluble reaction products of polyamines and monoepoxides, the acetone soluble reaction products of polyamines with unsaturated nitriles, such as acrylonitrile, imidazoline compounds as obtained by reacting monocarboxylic acids with polyamines, sulfur and/or phosphorus-containing polyamines as obtained by reacting a mercaptan or phosphine containing active hydrogen with an epoxide halide to form a halohydrin, dehydrochlorinating and then reacting the resulting product with a polyamine, soluble reaction product of polyamines with acrylate, and many other types of reaction products of the amines.

Still other curing agents that may be used include boron trifluoride and complexes of boron trifluoride with amines, ethers and phenols. Friedel-Crafts metals salts, such as aluminum chloride, zinc chloride, and other salts, such as zinc fluorborate, magnesium perchlorate and zinc fluosilicate: inorganic acids and partial esters as phosphoric acid and partial esters as phosphoric acid and partial esters thereof including n-butyl orthothiophosphate, diethyl orthophosphate and hexaethyltetraphosphate.

Another type curing agent to be employed includes polyamides containing active amino and/or carboxyl groups, and preferably those containing a plurality of amino hydrogen atoms. Examples of polybasic material used in making these polyamides include, among others, 1,10-decanedioic acid, 1,12-dodecanedienedioic acid, 1,20-eicosadienedioic acid, 1,14-tetradecanedioic acid, 1,18-octadecanedioic acid and dimerized and trimerized fatty acids as described above. Amines used in making the polyamides include preferably the aliphatic and cycloaliphatic polyamines as ethylene diamine, diethylene triamine, triethylene tetramine, tetraethylene pentamine, 1,4-diamino-butane, 1,3-diaminobutane, hexamethylene diamine and 3-(N-isopropylamino)propylamine. Especially preferred polyamides are those derived from the aliphatic polyamides containing no more than 12 carbon atoms and polymeric fatty acids obtained by dimerizing and/or trimerizing ethylenically unsaturated fatty acids containing up to 25 carbon atoms. These preferred polyamides preferably have a viscosity between 10 and 750 poises at 40°C, and preferably 20 to 250 poises at 40°C. Preferred polyamides also have amine values of 50 to 450.

Still another group of curing agents are those based on melamine reaction products containing methylol substituents.

Preferred curing agents are the aromatic hydroxyl containing compounds described herein, anhydrides of polybasic acids, polyamines and amides. More preferred curing agents include the preferred aromatic hydroxyl compounds described herein, aliphatic polyamines, polyglycoldiamines, polyoxypropylene diamines, polyoxypropylenetriamines, amidoamines, imidazolines, reactive polyamides, ketimines, araliphatic polyamines (i.e. xylylenediamine), cycloaliphatic amines (i.e. isphoronediamine or diaminocyclohexane) menthane diamine, 3,3-dimethyl-4,4-diamino-dicyclohexylmethane, heterocyclic amines (aminoethyl piperazine), aromatic polyamines, (methylene dianiline), diamino diphenyl sulfone, mannich base, phenalkamine and N,N'N''-tris(6-aminohexyl) melamine. Most preferred are cyanamide, dicyandiamide, and its derivatives, diaminodiphenyl sulphone and methylene dianiline.

Catalysts useful in this invention are those catalysts which catalyze the reaction of a polyepoxide with a curing agent, and which remain latent in the presence of the inhibitor at lower temperatures. Latent means herein that the catalyst does not catalyze the reaction at the lower temperatures. Preferably the catalyst is latent at temperatures of 150°C or below, and more preferably at 160°C or below. Latency is demonstrated by significantly higher stroke cure times when the inhibitor is present as compared to compositions not containing the inhibitor. Examples of preferred catalysts are compounds containing amine, phosphine, heterocyclic nitrogen, ammonium, phosphonium, arsonium or sulfonium moieties. More preferred catalysts are the heterocyclic nitrogen and amine containing compounds and even more preferred compounds are heterocylic nitrogen containing compounds.

Among preferable catalysts are those represented by the following formulas 12 or 13

Formula 12

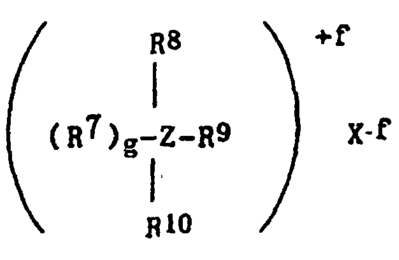

Formula 13

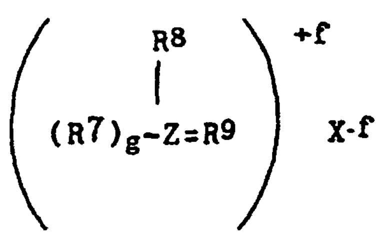

wherein each of $R^7$, $R^8$, $R^9$ and $R^{10}$ is independently a hydrocarbyl group having from 1 to 18, preferably from 1 to 9,

carbon atoms, or a hydrocarbyl group having from 1 to 18, preferably from 1 to 9 carbon atoms which group also contains one or more oxygen, sulfur, halogen, or nitrogen atoms or two of such $R^7$, $R^8$, $R^9$ and $R^{10}$ groups can combine to form a heterocyclic ring containing one or more atoms other than carbon atoms; each X is the anion portion of an acid of a relatively strong nucleophilic acid; Z is phosphorus, nitrogen, sulfur or arsenic; f has a value equal to the valence of the anion X; and g has a value of zero or 1 depending on the valence of Z.

Particularly suitable onium or amine compounds useful as catalysts include, for example, ethyltriphenyl phosphonium acetate, ethyltriphenyl phosphonium acetate·acetic acid complex, tetrabutyl phosphonium acetate, tetrabutyl phosphonium acetate·acetic acid complex, ethyltriphenyl phosphonium chloride, ethyl triphenyl phosphonium iodide, tetrabutyl phosphonium chloride, tetrabutyl phosphonium iodide, tetrabutylphosphonium hydroxide, tetrabutylammonium hydroxide, tetraethylammonium hydroxide, tetramethylammonium hydroxide, N-methylmorpholine, 2-methylimidazole, triethylamine, N,N,N',N'-tetramethylethylenediamine, ethyltri(2-hydroxyethyl)-ammonium hydroxide, ethyltri (2-ethoxyethyl)ammonium hydroxide, triethyl(2-thioethylethyl)ammonium hydroxide, N-methyl-N-methylenemethanaminium acetate, N-methyl-N-methylenemethanaminium acetate·acetic acid complex, N-methyl-N-methylenemethanaminium chloride, N-methyl-N-methylenemethanaminium iodide, N-methylpyridinium acetate, N-methylpyridinium acetate·acetic acid complex, N-methylpyridinium chloride, N-methylpyridinium iodide, 1-ethyl-2,3-dimethylimidazolium acetate, 1-ethyl-2,3-dimethyl-imidazolium acetate·acetic acid complex, 1-ethyl-2,3-dimethylimidazolium chloride, 1-ethyl-2,3-dimethyl-imidazolium iodide, N-methylquinolinium acetate, N-methylquinolinium acetate·acetic acid complex, N-methylquinolinium chloride, N-methylquinolinium iodide, N-methyl-1,3,5-triazinium acetate, N-methyl-1,3,5-triazinium acetate·acetic acid complex, N-methyl-1,3,5-triazinium chloride, N-methyl-1,3,5-triazinium iodide and any combination thereof.

The amine compounds which can be suitably employed herein include, for example, primary, secondary, tertiary, aliphatic, cycloaliphatic, aromatic or heterocyclic amines.

Preferable non-heterocyclic amines which can be employed herein include, those containing suitably from 1 to 60, more suitably from 2 to 27, most suitably from 2 to 18, carbon atoms. Particularly preferable amines include, for example, ethylamine, diethylamine, triethylamine, n-propylamine, di-n-propylamine, tri-n-propylamine, isopropylamine, diisopropylamine, triisopropylamine, butylamine, dibutylamine, tributylamine and methyldibutylamine, combinations thereof.

Among preferred tertiary amines that may be used as catalysts are those mono- or polyamines having an open chain or cyclic structure which have all of the amine hydrogen replaced by suitable substituents, such as hydrocarbon radicals, and preferably aliphatic, cycloaliphatic or aromatic radicals. Examples of these amines include, among others, methyl diethanol amine, triethylamine, tributylamine, dimethyl benzylamine, triphenylamine, tricyclohexyl amine, pyridine and quinoline. Preferred amines are the trialkyl, tricycloalkyl and triaryl amines, such as triethylamine, triphenylamine, tri(2,3-dimethylcyclohexyl)amine, and the alkyl dialkanol amines, such as methyl diethanol amines and the trialkanolamines such as triethanolamine. Weak tertiary amines, e.g., amines that in aqueous solutions give a pH less than 10, are particularly preferred.

Especially preferred tertiary amine accelerators are benzyldimethylamine and tris-dimethylaminomethyl phenol.

Preferable are the adducts of any aliphatic, cycloaliphatic, aromatic or heterocyclic secondary amine compounds and an epoxy resin having an average of more than one vicinal epoxide group per molecule, such as, for example, an adduct of 2-methylimidazole and the diglycidyl ether of bisphenol A. These adducts can easily be prepared by reacting the secondary amine compound with the epoxy resin at a temperature of from 25°C to 50°C, preferably from 60°C to 125°C, more preferably from 80°C to 100°C. The secondary amine compound and the epoxy resin are employed in amounts which provide a ratio of moles of secondary amine compound per epoxide group of from 1:1 to 5:1, preferably from 1:1 to 3:1, more preferably from :1 to 1.5:1. The adducts can be prepared in the presence of any suitable solvent such as, for example, alcohols, ethers, glycol ethers and ketones.

Examples of heterocyclic nitrogen compounds useful herein include those described in Copending, allowed patent application titled "Latent, Curable, Catalyzed Mixtures of Epoxy Containing and Phenolic Hydroxyl Containing Compounds" Serial No 07/274,250 filed November 18, 1988.

Preferable heterocyclic secondary and tertiary amines or nitrogen-containing compounds which can be employed herein include, for example, imidazoles, imidazolidines, imidazolines, oxazoles, pyrroles, thiazoles, pyridines, pyrazines, morpholines, pyridazines, pyrimidines, pyrrolidines, pyrazoles, quinoxalines, quinazolines, phthalozines, quinolines, purines, indazoles, indoles, indolazines, phenazines, phenarsazines, phenothiazines, pyrrolines, indolines, piperidines, piperazines and combinations thereof.

Among a more preferred class of heterocyclic nitrogen containing compounds useful as catalysts are those possessing in the heterocyclic ring (1) a substituted C=N-C group and (2) a secondary amino group, including the imidazoles, such as the substituted imidazoles and benzimidazoles according to formulas 14 and 15:

14

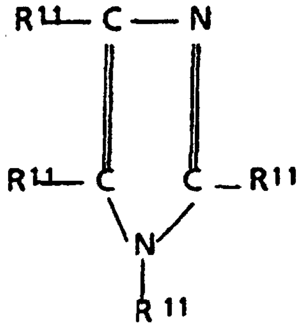

and

15

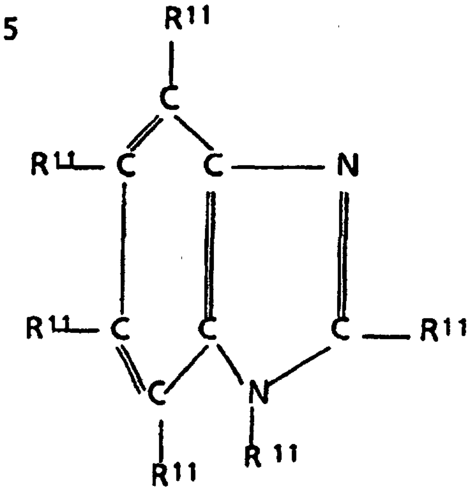

respectively, wherein $R^{11}$ is independently in each occurrence selected from hydrogen atoms, halogen atoms, or an organic radical, such as a hydrocarbon radical or a substituted hydrocarbon radical, for example, the ester, ether, amide, imide, amino, halogen, or mercapto substituted hydrocarbon radicals. Alternatively two adjacent $R^{11}$ can combine to form a 5- or 6-membered ring. Especially preferred imidazoles are those wherein $R^{11}$ is hydrogen or hydrocarbon radical and preferably an alkyl, alkenyl, cycloalkyl, cycloalkenyl, aryl, alkaryl or arylalkyl radicals, and particularly those containing no more than 15 carbon atoms.

A more detailed description of the chemistry of the imidazoles and benzimidazoles including their properties and structural formulas is found in the book by Klaus Hofmann entitled "Imidazole and Its Derivates" published by Interscience Publishers, Inc., New York (1953). Examples of imidazoles include, among others, imidazole, benzimidazole and substituted examples of preferable substituted imidazoles include: 2-methyl imidazole; 2-ethylimidazole, 2-propylimidazole, 2-butylimidazole, 2-pentylimidazole, 2-hexylimidazole, 2-cyclohexylimidazole, 2-phenylimidazole, 2-nonylimidazole, 2-undecylimidazole, 2-heptadecylimidazole, 2-phenyl-4-methylimidazole, 1-benzylimidazole, 1-ethyl-2-methylbenzimidazole, 2-methyl-5,6-benzimidazole, 1-vinylimidazole, 1-allyl-2-methylimidazole, 2-cyanoimidazole, 2-chloroimidazole, 2-bromoimidazole, 1-(2-hydroxypropyl)-2-methylimidazole, 2-phenyl-4,5-dimethylolimidazole, 2-phenyl-4-methyl-5-hydroxymethylimidazole, 2-chloromethylbenzimidazole, 2-hydroxybenzimidazole, 2-ethyl-4-methyl imidazole; 2-cyclohexyl-4-methyl imidazoles; 4-butyl-5-ethyl imidazole; 2-butoxy-4-allyl imidazole; 2-carboethyoxybutyl, 4-methyl-imidazole; 2-octyl-4-hexyl imidazole; 2-methyl-5-ethyl imidazole; 2-ethyl-4-(2-ethylamino) imidazole; 2-methyl-4-mercaptoethyl imidazole; 2,5-chloro-4-ethyl imidazole; and mixtures thereof. Especially preferred are the alkyl-substituted imidazoles; 2,5-chloro-4-ethyl imidazole; and phenyl substituted imidazoles, and mixtures thereof. Even more preferred are 2-methyl imidazole; 2-ethyl-4-methyl imidazole; 1,2-dimethylimidazole; and 2-phenyl imidazole. Especially preferred is 2-methyl imidazole.

Pyrazole compounds which can be employed herein include those which catalyze the curing of a polyepoxide and are well-known to those skilled in the art. Preferred pyrazole compounds include pyrazole, 1-methylpyrazole, 3-methylpyrazole, 4-butylpyrazole, 1-methyl-3-propylpyrazole, 3-ethyl-5-methylpyrazole, 1-(3-hydroxypropyl)pyrazole, 5-phenylpyrazole, 5-benzylpyrazole, 1-phenyl-3-methylpyrazole, 1-cyanopyrazole, 3-chloropyrazole, and 4-bromo-1-methyl-pyrazole.

Oxazole compounds which can be employed herein are those which catalyze curing of a polyepoxide and are well-known to those skilled in the art. Preferred oxazole compounds include oxazole, 4-methyloxazole, 2-methyloxazole, 4-butyloxazole, 2-methyl-5-propyloxazole, 2-ethyl-4-methyloxazole, 2-(3-hydroxypropyl)oxazole, 4-phenyloxazole, 5-benzyloxazole, 2-phenyl-5-methyloxazole, 2-cyanooxazole, 4-chlorooxazole, and 4-bromo-2-methyloxazole.

Imidazolidine compounds which can be employed herein are those which catalyze curing of a polyepoxide and are well-known to those skilled in the art. Preferable imidazolidine compounds include imidazolidine, 1-methylimidazolidine, 2-methylimidazolidine, 4-butylimidazolidine, 1-methyl-3-propylimidazolidine, 1-ethyl-4-methyl-imidazolidine, 1-(3-hydroxypropyl)imidazolidine, 2-phenylimidazolidine, 1-benzylimidazolidine, 2-phenyl-1-methylimidazolidine, 4-cyanoimidazolidine, 4-chloroimidazolidine, 4-bromo-1-methylimidazolidine, 5-chloroimidazolidine, and 5-bromo-1-methylimidazolidine.

Thiazole compounds which can be employed herein are those which catalyze the curing reaction and are well-known to those skilled in the art. Preferable thiazole compounds include thiazole, 2-methylthiazole, 5-methylthiazole, 4-butylthiazole, 2-methyl-4-propylthiazole, 4-ethyl-5-methylthiazole, 2-(3-hydroxypropyl)thiazole, 2-phenylthiazole, 2-benzylthiazole, 4-phenyl-5-methylthiazole, 2-cyanothiazole, 5-chlorothiazole, and 5-bromo-2-methylthiazole.

Pyrrole compounds which can be employed herein are those which catalyze the curing reaction and are well-knwon to those skilled in the art. Preferred pyrrole compounds include pyrrole, 1-methylpyrrole, 2-methylpyrrole, 3-butylpyrrole, 1-methyl-2-propylpyrrole, 2-ethyl-3-methylpyrrole, 1-(3-hydroxypropyl)pyrrole, 2-phenylpyrrole, 1-benzylpyrrole, 2-phenyl-1-methylpyrrole, 3-cyanopyrrole, 3-chloropyrrole, and 2-bromo-1-methylpyrrole.

Pyridine compounds which can be employed herein are those which catalyze the curing reaction and are well-knwon to those skilled in the art. Preferable pyridine compounds include pyridine, 2-methylpyridine, 3-methylpyridine, 4-butylpyridine, 2-methyl-3-propylpyridine, 3-ethyl-4-methylpyridine, 4-(3-hydroxypropyl)pyridine, 2-phenylpyridine, 3-benzylpyridine, 4-phenyl-2-methylpyridine, 3-cyanopyridine, 2-chloropyridine, and 3-bromo-5-methylpyridine.

Pyrazine compounds which can be employed herein are those which catalyze the curing reaction and are well-known to those skilled in the art. Preferable pyrazine compounds include pyrazine, 2-methylpyrazine, 3-methylpyrazine, 2-butylpyrazine, 2-methyl-5-propylpyrazine, 2-ethyl-6-methylpyrazine, 2-(3-hydroxypropyl)pyrazine, 2-phenylpyrazine, 2-benzylpyrazine, 2-phenyl-3-methylpyrazine, 2-cyanopyrazine, 2-chloropyrazine, and 2-bromo-5-methylpyrazine.

Pyridazine compounds which can be employed herein are those which catalyze the curing reaction and are well-known to those skilled in the art. Pyridazine compounds include, for example, pyridazine, 3-methylpyridazine, 4-methylpyridazine, 3-butylpyridazine, 3-methyl-4-propylpyridazine, 3-ethyl-6-methylpyridazine, 4-(3-hydroxypropyl)-pyridazine, 3-phenylpyridazine, 4-benzylpyridazine, 4-phenyl-5-methylpyridazine, 4-cyanopyridazine, 4-chloropyridazine, and 3-bromo-5-methylpyridazine.

Pyrrolidine compounds which can be employed herein are those which catalyze the curing reaction and are well-known to those skilled in the art. Preferable pyrrolidine compounds include pyrrolidine, 1-methylpyrrolidine, 4-phenylpyrrolidine, 2-methylpyrrolidine, 3-methylpyrrolidine, 1-butylpyrrolidine, 1-methyl-2-propylpyrrolidine, 3-ethyl-4-methylpyrrolidine, 2-(3-hydroxypropyl)pyrrolidine, 1-phenyl-2-methylpyrrolidine, 2-cyanopyrrolidine, 2-chloropyrrolidine, and 2-bromo-1-methylpyrrolidine.

Morpholine compounds which can be employed herein are those which catalyze the curing reaction and are well-known to those skilled in the art. Preferable morpholine compounds include morpholine, 4-methylmorpholine, 3-methylmorpholine, 4-butylmorpholine, 4-methyl-3-propylmorpholine, 2-ethyl-3-methylmorpholine, 4-(3-hydroxypropyl)-morpholine, 2-phenylmorpholine, 4-benzylmorpholine, 3-phenyl-1-methylmorpholine, 3-cyanomorpholine, 3-chloromorpholine, and 3-bromo-4-methylmorpholine.

Pyrimidine compounds which can be employed herein are those which catalyze the curing reaction and are well-known to those skilled in the art. Preferable pyrimidine compounds include pyrimidine, 2-methylpyrimidine, 4-methylpyrimidine, 2-butylpyrimidine, 2-methyl-4-propylpyrimidine, 4-ethyl-5-methylpyrimidine, 2-(3-hydroxypropyl)pyrimidine, 2-phenylpyrimidine, 2-benzylpyrimidine, 4-phenyl-2-methylpyrimidine, 4-cyanopyrimidine, 2-chloropyrimidine, and 4-bromo-2-methylpyrimidine.

Quinoxaline compounds which can be employed herein are those which catalyze the curing reaction and well-known to those skilled in the art. Preferable quinoxaline compounds include quinoxaline, 2-methylquinoxaline, 5-methylquinoxaline, 2-butylquinoxaline, 2-methyl-3-propylquinoxaline, 5-ethyl-6-methylquinoxaline, 2-(3-hydroxypropyl)quinoxaline, 2-phenylquinoxaline, 5-benzylquinoxaline, 2-phenyl-5-methylquinoxaline, 2-cyanoquinoxaline, 2-chloroquinoxaline, and 2-bromo-5-methylquinoxaline.

Quinazoline compounds which can be employed herein are those which catalyze the curing reaction and are well-known to those skilled in the art. Preferable quinazoline compounds include quinazoline, 2-methylquinazoline, 4-methylquinazoline, 2-butylquinazoline, 2-methyl-4-propylquinazoline, 5-ethyl-6-methylquinazoline, 2-(3-hydroxypropyl)quinazoline, 2-phenylquinazoline, 2-benzylquinazoline, 2-phenyl-4-methylquinazoline, 4-cyanoquinazoline, 4-chloroquinazoline, and 2-bromo-4-methylquinazoline.

Phthalazine compounds which can be employed herein are those which catalyze the curing reaction and are well-known to those skilled in the art. Preferable phthalazine compounds include phthalazine, 1-methylphthalazine, 6-methylphthalazine, 1-butylphthalazine, 1-methyl-4-propylphthalazine, 1-ethyl-6-methylphthalazine, 1-(3-hydroxypropyl)phthalazine, 5-phenylphthalazine, 1-benzylphthalazine, 1-phenyl-4-methylphthalazine, 1-cyanophthalazine, 1-chlorophthalazine, and 1-bromo-4-methylphthalazine.

Quinoline compounds which can be employed herein are those which catalyze the curing reaction and are well-known to those skilled in the art. Preferable quinoline compounds include quinoline, 2-methylquinoline, 3-methylquinoline, 4-butylquinoline, 5-methyl-2-propylquinoline, 2-ethyl-3-methylquinoline, 3-(3-hydroxypropyl)quinoline, 3-phenylquinoline, 4-benzylquinoline, 3-phenyl-2-methylquinoline, 3-cyanoquinoline, 4-chloroquinoline, and 2-bromo-3-methylquinoline.

Purine compounds which can be employed herein are those which catalyze the curing reaction and are well-known to those skilled in the art. Preferable purine compounds include purine, 2-methylpurine, 8-methylpurine, 6-butylpurine, 2-methyl-8-propylpurine, 6-ethyl-8-methylpurine, 8-(3-hydroxypropyl)purine, 2-phenylpurine, 2-benzylpurine, 6-phenyl-2-methylpurine, 8-cyanopurine, 2-chloropurine, and 8-bromo-2-methylpurine.

Indazole compounds which can be employed herein are those which catalyze the curing reaction and are well-known to those skilled in the art. Preferable indazole compounds include indazole, 1-methylindazole, 3-methylindazole, 1-butylindazole, 1-methyl-3-propylindazole, 1-ethyl-5-methylindazole, 3-(3-hydroxypropyl)indazole, 3-phenylindazole, 6-benzylindazole, 6-phenyl-1-methyl-indazole, 3-cyanoindazole, 5-chloroindazole, and 3-bromo-1-methylindazole.

Indole compounds which can be employed herein are those which catalyze the curing reaction and are well-known to those skilled in the art. Preferable indole compounds include indole, 1-methylindole, 2-methylindole, 3-butylindole, 1-methyl-2-propylindole, 2-ethyl-3-methylindole, 1-(3-hydroxypropyl)indole, 2-phenylindole, 1-benzyl-indole, 2-phenyl-1-methylindole, 2-cyanoindole, 5-chloroindole, and 3-bromo-1-methylindole.

Indolizine compounds which can be employed herein are those which catalyze the curing reaction and are well-known to those skilled in the art. Preferable indolizine compounds include indolizine, 1-methylindolizine, 2-methylindolizine, 3-butylindolizine, 5-methyl-1-propylindolizine, 2-ethyl-1-methyl-indolizine, 6-(3-hydroxypropyl)indolizine, 3-phenylindolizine, 7-benzylindolizine, 2-phenyl-3-methylindolizine, 5-cyanoindolizine, 7-chloroindolizine, and 3-bromo-5-methylindolizine.

Phenazine compounds which can be employed herein include are those which catalyze the curing reaction and are well-known to those skilled in the art. Preferable phenazine compounds include phenazine, 1-methylphenazine, 2-methylphenazine, 2-butylphenazine, 1-methyl-7-propylphenazine, 1-ethyl-4-methylphenazine, 2-(3-hydroxypropyl) phenazine, 1-phenylphenazine, 1-benzylphenazine, 1-phenyl-7-methylphenazine, 2-cyanophenazine, 1-chlorophenazine, and 1-bromo-2-methyl-phenazine.

Phenarsazine compounds which can be employed herein are those which catalyze the curing reaction and are well-known to those skilled in the art. Preferable phenarsazine compounds include phenarsazine, 1-methylphenarsazine, 2-methylphenarsazine, 4-butylphenarsazine, 1-methyl-6-propylphenarsazine, 2-ethyl-3-methylphenarsazine, 1-(3-hydroxypropyl)-phenarsazine, 4-phenylphenarsazine, 3-benzylphenarsazine, 2-phenyl-7-methylphenarsazine, 3-cyanophenarsazine, 1-chlorophenarsazine, and 1-bromo-8-methylphenarsazine.

Phenothiazine compounds which can be employed herein are those which catalyze the curing reaction and are well-known to those skilled in the art. Preferable phenothiazine compounds include phenothiazine, 10-methylphenothiazine, 1-methylphenothiazine, 2-butylphenothiazine, 10-methyl-4-propylphenothiazine, 2-ethyl-3-methylphenothiazine, 4-(3-hydroxypropyl)phenothiazine, 10-phenylphenothiazine, 1-benzylphenothiazine, 10-phenyl-4-methylphenothiazine, 7-cyanophenothiazine, 4-chlorophenothiazine, and 4-bromo-10-methylphenothiazine.

Pyrroline compounds which can be employed herein are those which catalyze the curing reaction and are well-known to those skilled in the art. Preferable pyrroline compounds include pyrroline, 2-methylpyrroline, 4-methylpyrroline, 5-butylpyrroline, 5-methyl-1-propyl-pyrroline, 1-ethyl-3-methylpyrroline, 1-(3-hydroxy-propyl)pyrroline, 5-phenylpyrroline, 1-benzylpyrroline, 1-phenyl-4-methylpyrroline, 3-cyanopyrroline, 5-chloropyrroline, and 2-bromo-1-methylpyrroline.

Preferable indoline compounds which can be employed herein are those which catalyze the curing reaction and are well-known to those skilled in the art. Preferable indoline compounds include, for example, indoline, 1-methylindoline, 2-methylindoline, 3-butylindoline, 1-methyl-2-propyl-indoline, 2-ethyl-2-methylindoline, 1-(3-hydroxy-propyl) indoline, 1-phenylindoline, 1-benzylindoline, 1-phenyl-2-methylindoline, 5-cyanoindoline, 7-chloroindoline, and 5-bromo-1-methylindolin.

Preferable piperidine compounds which can be employed herein are those which catalyze the curing reaction and are well-known to those skilled in the art. Preferable piperidine compounds include piperidine, 1-methylpiperidine, 2-methylpiperidine, 3-butylpiperidine, 1-methyl-2-propylpiperidine, 2-ethyl-4-methylpiperidine, 1-(3-hydroxypropyl)-piperidine, 1-phenylpiperidine, 1-benzylpiperidine, 1-phenyl-2-methylpiperidine, 4-cyanopiperidine, 3-chloropiperidine, and 4-bromo-1-methylpiperidine.

Piperazine compounds which can be employed herein are those which catalyze the curing reaction and are well-known to those skilled in the art. Preferable piperazine compounds include piperazine, 1-methylpiperazine, 2-methylpiperazine, 3-butylpiperazine, 1-methyl-4-propylpiperazine, 1-ethyl-3-methylpiperazine, 1(3-hydroxypropyl)-piperazine, 2-phenylpiperazine, 1-benzylpiperazine, 1-methyl-3-phenylpiperazine, 2-cyanopiperazine, 2-chloropiperazine, and 1,4-dimethyl-2-bromopiperazine.

The inhibitor is boric acid or maleic acid. Boric acid as used herein refers to boric acid or derivatives thereof, including metaboric acid and boric anhydride. It is believed that boric acid and its derivatives are all capable of functioning as an inhibitor when added to the compositions of the invention either in the form added or in a converted form. Boric acid is preferred over maleic acid. Inhibitor as used herein shall mean a compound which functions to retard the curing reaction at lower temperatures, preferably, 140°C or lower, more preferably 150°C or lower. Inhibition is demonstrated by a longer stroke cure time (gel time) for compositions containing the inhibitor as compared to like compositions not containing the inhibitor.

The inhibitor and catalysts may be separately added to the compositions of this invention, or may be added

as a complex. The complex is formed by contacting and intimately mixing a solution of the inhibitor with a solution of the catalyst. Optionally, an acid having a weak nucleophilic anion may be present. Such contacting generally is performed at ambient temperature, although other temperatures may be used for example temperatures of from 0°C to 100°C, more preferably from 20°C to 60°C. The time of contacting is that sufficient to complete formation of the complex, and depends on the temperature used, with from 1 to 120 minutes preferred, and from 10 to 60 minutes more preferred. The solvents used for each component are preferably miscible. Most preferably the same solvent is used. Preferred solvents for the catalyst and the inhibitor are polar solvents, with alcohols being preferred. Lower alcohols are even more preferred, with methanol most preferred. Alternatively, the components of the complex may be contacted neat, in the absence of solvent and reacted as described.

In preferred embodiments the solvents for boric acid used in coating compositions of this invention are polar solvents which do not contain active hydrogen atoms or dihydroxy and trihydroxy hydrocarbons optionally containing ether moieties. Examples of polar solvents without active hydrogen atoms are N-methyl pyrrolidinone, dimethylsulfoxide.

The di and trihydroxy hydrocarbons which optionally contain ether moieties, are low molecular weight hydrocarbons or glycol ethers having two or three hydroxy groups. Preferred are $C_{2-4}$ di or trihydroxy compounds. Examples include 1,2 propane diol, diethyleneglycol, ethylene glycol and glycerine. The use of $C_2$-$C_4$ di or trihydroxy compounds as solvents for boric acid in the coating compositions of this invention results in increased gel times for the compositions. Further, compositions containing boric acid in such solvents demonstrate stability as demonstrated by consistent gel times over a period of several days. It has been further discovered that when $C_{2-4}$ di or trihydroxy compounds are used to solvents for boric acid in compositions of this invention, laminates prepared therefrom can be treated in treaters at significantly faster speeds.

The amount of the inhibitor present relative the catalyst in the composition can be adjusted to adjust the gel time of the epoxy resin composition. At a desired catalyst level the relative amount of inhibitor can be decreased to decrease the gel time. To increase the gel time the amount of inhibitor can be increased without changing the catalyst level.

Alternatively, the catalytic products of the present invention can be prepared in situ in the presence of the epoxy resin by adding each component to the epoxy resin in any order under essentially the same conditions as mentioned above.

The Molar ratio of inhibitor, and optional acid with a weak nucleophilic anion, to catalyst is that ratio which is sufficient to inhibit the reaction of the polyepoxide or advanced epoxy resin as exhibited by an increase in gel time as compared to a like composition free of inhibitor. Simple experimentation can determine the particular levels of inhibitor and optional acid with a weak nucleophilic anion which will cause the aforementioned increase in gel time but still allow a complete cure at elevated temperatures. A preferable Molar ratio range of inhibitor, and optional acid with a weak nucleophilic anion, to catalyst where up to 2.0 phr of boric acid is used, is from 0.1:1.0 to 4.0:1.0, with a more preferred range being from 0.4:1.0 to 3.0:1.0, with an even more preferred range of 0.7:1.0 to 1.4:1.0 with the most preferred range being 0.75:1.0 to 1.35:1.0.

The most preferred ratios depend upon which onium or amine compound is mixed with the boric acid or the particular mixture of boric acid and acid having a weak nucleophilic anion. For example, the preferred ratio of moles of boric acid or mixture of boric acid and acid having a weak nucleophilic anion per mole of imidazole compound is from 0.85:1 to 1.12:1 while the most preferred ratio is in the range of from 0.93:1 to 1.1:1. For phosphonium compounds, the preferred ratio is from 0.95:1 to 1.35:1, more preferably from 1.1:1 to 1.25:1 moles of acid per mole of phosphonium compound. For other catalysts, it is easy to determine the optimum ratios of boric acid to onium or amine compound by mixing the components together in various ratios and conducting simple, routine experiments. When the amount of boric acid or mixture of boric acid and acid having a weak nucleophilic anion is less than about 0.6 mole per mole of imidazole the catalyst is less latent and begins to approach the reactivity of the original imidazole prior to reaction with the acid or acid salt. When the amount of boric acid or mixture of boric acid and acid having a weak nucleophilic anion is more than about 1.4 moles per mole of phosphonium, the catalyst becomes less latent. When the amount of acid or acid salt is more than about 1.14 moles per mole of imidazole, the catalyst becomes less latent.

When a mixture of boric acid and an acid having a weak nucleophilic anion are employed, they are employed in an amount which provides a ratio of moles of boric acid to moles of acid having a weak nucleophilic anion of from 0.1:1 to 0.9:1, preferably from 0.2:1 to 0.8:1, more preferably from 0.3:1 to 0.7:1.

The catalytic products of the present invention can be employed alone or in combination with other catalysts, preferably catalytic products resulting from reacting the onium or amine compounds or a combination thereof with an inorganic acid containing a weak nucleophile. By the term "weak nucleophile" or "weak nucleophilic", it is meant that the material has a nucleophilicity value "n" of greater than zero and less than 2.5 as described by C. G. Swain and C. B. Scott in J. Am. Chem. Society, Vol. 75, p 141 (1953).

Preferable inorganic acids having a weak nucleophilic anion or weak nucleophile include, for example, fluoboric acid, fluoarsenic acid, fluoantimonic acid, fluophosphoric acid, chloroboric acid, chloroarsenic acid, chloroantimonic acid, chlorophosphoric acid, perchloric acid, chloric acid, bromic acid, iodic acid and any combination thereof. The most preferable is fluoboric acid.

Fluoboric acid is sometimes referred to as fluoroboric acid or hydrogen tetrafluoroborate. Any of these expressions refer to the chemical represented by the formula, $HBF_4$.

In one embodiment the epoxy resin composition comprises a diepoxide, a dihdyroxyhydrocabon or halogenated dihydroxyhydrocarbon, an epoxy curing agent which does not contain phenolic hydroxyl moieties, a catalyst for the epoxy curing reaction, and an inhibitor. In this embodiment the diepoxide undergoes reaction with both the dihydroxyhydrocarbon or halogenated dihydroxy hydrocarbon and the curing agent. Thus the diepoxide is advanced in situ during the reaction. In one embodiment, the diepoxide, dihydroxy hydrocarbon or halogenated dihydroxy hydrocarbon and inhibitor can be contacted prior to the addition of the curing agent and catalyst. Those polyfunctional dihydroxyhydrocarbons or halogenated dihydroxy hydrocarbons useful are well-known in the arc see for example Lee and Neville, supra; and Bertram U.S. Patent No. 4,594,291, col. 8 Lines 24 to 36.

All concentrations of components used in this invention are quoted in parts by weight of components per hundred parts of resin (phr). Such hundred parts of resin refers specifically to the polyepoxide included in the composition. The amount of curing agent which may be present may vary depending upon the particular curing agent used. Generally preferred amounts of curing agent are from 0.5 to 30 parts of curing agent per hundred parts of resin. More preferably from 1.0 to 10.0, and most preferably from 2 to 4 parts. In the embodiment where the curing agent is an aromatic hydroxyl-containing compounds such curing agent may be employed in amounts which provide a ratio of aromatic hydroxyl groups to epoxy groups preferably from 0.05:1 to 20:1, more preferably from 0.1:1 to 10:1, most preferably from 0.2:1 to 5:1. The catalysts are employed in a sufficient amount to result in a substantially complete cure of the epoxy resin, with some crosslinking. Preferably the catalyst is used in an amount of from about .01 to 10 parts per hundred parts of resin, with from .05 to 5.0 parts per hundred parts of resin being more preferred and from 0.1 to 2.0 catalyst per hundred parts of resin being most preferred. Alternatively, the quantity of catalyst is stated in millimoles per epoxy equivalent preferably from 0.05 to 100, more preferably from 0.1 to 50, even more preferable from 0.5 to 20, most preferably from 1 to 10 millimoles of catalyst per epoxide equivalent. The amount of inhibitor used is that amount which significantly increases the stroke cure time (gel time) of a composition when compared to a similar composition not containing the inhibitor. In one embodiment, the inhibitor is present in amounts up to 2.0 phr, more preferably up to 1.5 phr. Preferably 0.05 phr or more of inhibitor is used, more preferably 0.1 phr or more is used. In those embodiments where an equivalent amount of catalyst is used, or where a complex of inhibitor and catalyst is prepared prior to contacting with the polyepoxide, up to 5.0 phr inhibitor may be used, provided the stroke cure rate is significantly increased.

The compositions of this invention can be used to coat any article for which a coating is desired. Such article can be coated, with the composition, and the coating can be partially cured or fully cured. In that the embodiment where the coating is partially cured, the article may be further processed and the partially cured resin can be finally cured. The article coated can be any substrate, for example metal, cement and reinforcing material. In a preferred embodiment the article is a reinforcing material for composites or laminates.

The reinforcing material which may be coated with the compositions of this invention include any material which would be used by the skilled artisan in formation of composites, prepregs and laminates. Examples of the forms of such materials are cloth, mesh, web, fibers, or the like. Preferably, such materials are made from glass, fiberglass, paper, plastics such as aromatic polyamides and graphite. Preferred materials include glass or fiberglass, in cloth or web form. Other additives may also be present including fillers, dyes, pigments, surfactants and flow control agents.

Compositions containing polyepoxide, curing agent, catalyst and inhibitor may be contacted with an article used in any method known to those skilled in the art. Examples of such contacting methods include powder coating, spray coating, and contacting the article with a bath containing the composition. In a preferred embodiment the article is contacted with the composition in a bath. Preferably the bath contains a solids levels of from 50 to 75 percent solids. In such a bath the various components of the epoxy resin compositions are dissolved or suspended in the bath. A single solvent may be used for the bath, but in many applications a separate solvent is used for each component added to the mixture. It is preferable that the various solvents used be miscible with one another. Such solvents or diluents, include those which are volatile and escape from the composition prior to cure. Preferred solvents for the epoxy resins are ketones, including acetone and methylethylketone. Preferred solvents for the curing agents are slightly polar solvents, amides, e.g. DMF, ether alcohols, e.g., methyl, ethyl, propyl or butyl ethers of ethylene glycol, diethylene glycol, propylene glycol or dipropylene glycol for example, ethylene glycol monomethyl ether, 1 methoxy-2-propanol. The catalysts and inhibitors are preferably dissolved in polar solvents, in particular alcohols, preferably lower alkanols and most preferably methanol.

In one embodiment, the invention is a process for preparing prepregs from the resin composition and the reinforcing material. Such process comprises contacting the reinforcing material with an intimately mixed bath comprising: a polyepoxide in a solvent; a curing agent for the polyepoxide in a solvent; an inhibitor comprising boric acid or maleic acid in a polar solvent; and a compound which catalyzes the curing of the polyepoxide with the curing agent

in a polar solvent. The coating occurs under condition such that the reinforcing material is coated with epoxy resin, curing agent, inhibitor, and catalyst. Thereafter the coated reinforcing materials are passed through a heated zone at a temperature sufficient to cause the solvents to evaporate, but below the temperature which the polyepoxide undergoes significant cure during the residence time in the heated zone. The reinforcing material preferably has a residence time in the bath of from 0.1 min to 10 min, more preferably from 0.3 min to 8 min, and most preferably from 0.5 min to 3 min. The temperature of such bath is preferably from 0°C to 100°C, more preferably from 10°C to 40°C and most preferably from 15°C to 30°C. The residence time of the coated reinforcing material in the heated zone is from 0.5 to 15 min, more preferably from 1 to 10 min, and most preferably from 1.5 to 5 min. The temperature of the heated zone is sufficient to cause any solvents remaining to volatilize away yet not so high as to result in a complete curing of the components. Preferable temperatures of such zone are from 80°C to 230°C, more preferably from 100°C to 200°C, and most preferably from 140°C to 190°C. Preferably there is some means in the heated zone to remove the volatile solvent, either by passing an inert gas through the oven; or drawing a slight vacuum on the oven. In many embodiments the coated materials are exposed to zones of increasing temperature. The first zones are designed to cause the solvent to volatilize so it can be removed. The later zones are designed to result in partial cure of the polyepoxide, i.e. so called B-staging.

In some embodiments the coated article may be then transported to another location for further processing, or alternatively the material may be further processed immediately after solvent removal. In such further processing, several segments or parts of the coated reinforcing material are brought in contact with one another. Thereafter, the contacted parts are exposed to elevated pressures and temperatures sufficient to cause the epoxy resin to cure wherein the resin on adjacent parts react to form a continuous epoxy resin matrix between and about the reinforcing material. Before being cured the parts may be cut and stacked or folded and stacked into a part of desired shape and thickness. The pressures use can be anywhere from 1 to 200 kg/cm$^2$, with from 10 to 100 kg/cm$^2$ being preferred. The temperature used to cure the resin in the parts or laminates, depends upon the particular residence time, pressure used, and resin used. Preferred temperature which may be used are from 100 to 190°C, more preferably from 120°C to 180°C, and most preferably from 140°C to 175°C. The residence times may be anywhere from 30 min to 300 min, more preferably from 45 to 200 min, and most preferably from 60 to 180 min. One embodiment of such a process is known as a continuous process. In such process, the reinforcing material is taken from the oven and appropriately arranged into the desired shape and thickness and pressed at very high temperatures for short times, in particular such high temperatures are from 180 to 250°C, more preferably 190°C to 210°C, at times of 1 to 10 min and from 2 to 5 min. Such high speed pressing allows for the more efficient utilization of processing equipment. In such embodiments the preferred reinforcing material is a glass, web or woven cloth.

In some embodiments it is desirable to subject the laminate or final product to a post cure outside of the press. This step is designed to complete the curing reaction. The post cure is usually performed at from 130°C to 200°C for from 20 to 200 minutes. This post cure step may be performed in a vacuum to remove any components which may volatilize.

The ultimate coated reinforced parts prepared from the composition of this invention often demonstrate a higher Tg than where the compositions not within the scope of this invention are used. In some embodiments the Tg is at least 5°C higher than parts prepared similarly using conventional resins. More preferably the Tg is increased by at least 10°C. The parts prepared using the composition of this invention, demonstrate a higher solvent resistance, e. g., demonstrate a pick-up of less than 1.0 percent N-methyl pyrrolidone in test methods conditions.

Furthermore such parts exhibit a higher thermal performance as there is little or no solvent entrapped. The formulations of this invention preferably exhibit longer gel times at certain temperatures as compared to prior art formulations.

The following examples are presented to illustrate the invention and are not intended to limit the scope of the claims. Unless otherwise stated all parts and percentages are by weight.

## Examples

### Example 1 - Preparation of Varnish

A varnish is prepared by mixing and blending four solutions with agitation in a container for approximately 30 minutes. The four solutions comprise 125 parts of a brominated epoxy resin having a bromine content of 20 percent and an epoxy equivalent weight of 430, prepared from the diglycidyl ether of bisphenol A and tetrabromobisphenol A which is dissolved in methylethylketone (MEK) with on 80 percent solids (non-volatiles) content; 2.19 parts of boric acid solution (20 percent in methanol); 36 parts of a solution of dicyandiamide (7.5 percent) dissolved in monomethylether of propylene glycol (69.9 percent) and dimethylformamide (22.6 percent); 4 parts of 2-methyl imidazole (2-MI) solution (10 percent in methanol).

Example 2 - Preparation of Varnish

A second varnish is prepared by mixing and blending the following four solutions with simple agitation in a container for approximately 30 minutes: 125 parts of a brominated epoxy resin having a bromine content of 20 percent and an epoxy equivalent weight of 430, prepared from the diglycidyl ether of bisphenol A and tetrabromobisphenol A dissolved in methylethylketone (MEK) to have 80 percent solids content; 1.65 parts of boric acid solution (20 percent in methanol); 40 parts of dicyandiamide (7.5 percent) dissolved in monomethyl ether of propylene glycol (69.9 percent) and dimethylformamide (22.6 percent); and 3.5 parts of 2-methyl imidazole (2-MI) solution (10 percent in methanol).

Example 3 - Preparation of Varnish

A solution containing 62.2 parts of a polyglycidylether of 2,2-bis(4-hydroxy-phenyl) propane having an epoxide equivalent weight of about 180, 32.8 parts of tetrabromobisphenol A, and 5.0 parts of monomethyl ether of propylene glycol is prepared by blending and mixing the polyglycidyl ether and tetrabromobisphenol A (TBBA) at room temperature and heating to 130°C. Approximately 30 min is required to obtain a homogeneous mixture. The mixture is cooled to 70°C and the monomethyl ether of propylene glycol is added. Another 30 minutes is required to obtain a homogeneous solution.

A third varnish is prepared by mixing and blending the above described solution with the following three solutions with simple agitation in a container for approximately 30 minutes: 1.57 parts of boric acid solution (20 percent in methanol); 34.2 parts of dicyandiamide (7.5 percent) dissolved in monomethyl ether of propylene glycol (69.9 percent) and dimethylformamide (22.6 percent); and 3.8 parts of 2-methyl imidazole solution (10 percent in methanol).

Example 4 - Preparation of Varnish

A fourth varnish is prepared by blending and mixing the following four solutions by simple agitation in a container for approximately 30 minutes: 125 parts of a brominated epoxy resin having a bromine content of 20 percent and an epoxy equivalent weight of 418, prepared from the diglycidyl ether of bisphenol A and tetrabromobisphenol A dissolved in methylethylketone to have 80 percent solids content; 4.5 parts of a boric acid solution (20 percent in methanol); 40 parts of dicyandiamide (7.5 percent) dissolved in monomethyl ether of propylene glycol (69.9 percent) and dimethylformamide (22.6 percent); and 1.6 parts of a 2-methyl imidazole solution (50 percent in methanol).

Example 5 - Preparation of Varnish - not an Example of the Invention

A varnish is prepared by mixing and blending the following three solutions by simple agitation in a container for approximately 30 minutes: 125 parts of a brominated epoxy resin having a bromine content of 20 percent and an epoxy equivalent weight of 430, prepared from the diglycidyl ether of bisphenol A and tetrabromobisphenol A which is dissolved in methylethylketone (MEK) with an 80 percent solids (non-volatiles) content; 40 parts of dicyandiamide (7.5 percent) dissolved in monomethyl ether of polypropylene glycol (69.9 percent) and dimethylformamide (22.6 percent); and 1 part of 2-methyl imidazole in methanol (10 percent solution).

Example 6 - Preparation of Varnish - not an Example of the Invention

A varnish'is prepared by mixing and blending the following three solutions by simple agitation in a container for approximately 30 minutes: 125 parts of a brominated epoxy resin having a bromine content of 20 percent and an epoxy equivalent weight of 430, prepared from the diglycidyl ether of bisphenol A and tetrabromobisphenol A which is dissolved in methylethylketone (MEK) with an 80 percent solids (non-volatiles) content; 40 parts of dicyandiamide (7.5 percent) dissolved in monomethyl ether of polypropylene glycol (69.9 percent) and dimethylformamide (22.6 percent); and 2.5 parts of 2-methyl imidazole in methanol (10 percent solution).

Example 7 - Preparation of Varnish

A varnish is prepared by mixing and blending the following four solutions by simple agitation in a container for approximately 30 minutes: 125 parts of a brominated epoxy resin having a bromine content of 20 percent and an epoxy equivalent weight of 430, prepared from the diglycidyl ether of bisphenol A and tetrabromobisphenol A dissolved in methylethylketone (MEK), and having an 80 percent solids content; 40 parts of dicyandiamide (7.5 percent) dissolved in monomethyl ether of propylene glycol (69.9 percent) and dimethylformamide (22.6 percent); and 1.67 parts of a solution resulting from mixing 82.1 parts of 2-methyl imidazole and 63.65 parts of boric acid dissolved in 97.1 parts of methanol to give a 60 percent solids solution.

Example 8 - Preparation of Varnish

A solution containing 62.2 parts of a polyglycidylether of 2,2-bis(4-hydroxy-phenyl) propane having 32.8 parts of tetrabromobisphenol A, and 5.0 parts of acetone is prepared by blending and mixing the polyglycidyl ether and tetrabromobisphenol A (TBBA) at room temperature and heating to 130°C. Approximately 30 min is required to obtain a homogeneous mixture. The mixture is cooled to 70°C and the acetone is added. Another 30 minutes is required to obtain a homogeneous solution.

A varnish is prepared by mixing and blending the above described solution with the following two solutions with simple agitation in a container for approximately 30 minutes: 38 parts of dicyandiamide (7.5 percent) dissolved in monomethyl ether of propylene glycol (69.9 percent) and dimethylformamide (22.6 percent); and 1.425 parts of the product resulting from mixing 82.1 parts of 2-methyl imidazole and 63.65 parts of boric acid dissolved in 97.1 parts of methanol resulting in a solution having 60 percent solids.

Example 9 - Preparation of Varnish

A varnish is prepared by blending and mixing the following three solutions by simple agitation in a container for approximately 30 minutes; 125 parts of brominated epoxy resin having a bromine content of 20 percent and an epoxy equivalent weight of 430, prepared from the diglycidyl ether of bisphenol A and a tetrabromobisphenol A dissolved in methylethylketone (MEK) to have 80 percent solids content; 40 parts of dicyandiamide (7.5 percent) dissolved in monomethyl ether of propylene glycol (69.9 percent) and dimethylformamide (22.6 percent); and 3.17 parts of the product resulting from mixing 82.1 parts of 2-methyl imidazole and 63.65 parts of boric acid dissolved in 97.1 parts of methanol to give 60 percent solids.

Example 10 - Preparation of Varnish - not an Example of the Invention

A varnish is prepared by blending and mixing the following solutions by simple agitation in a container for approximately 30 minutes; 58.95 parts of the glycidyl polyether of 2,2-bis (4-hydroxy-phenyl) propane having an epoxide equivalent weight of about 180; 31.05 parts of tetrabromobisphenol A and 10 parts of methylethylketone; 40.8 parts of dicyandiamide (7.5 percent) dissolved in monomethyl ether of propylene glycol (69.9 percent) and dimethylformamide (22.6 percent); and 5.4 parts of 2-ethyl, 4-methyl imidazole dissolved in methanol (10 percent solution).

Example 11 - Preparation of Varnish - not an Example of the Invention

A laminating varnish is prepared by mixing and blending the following solutions by simple agitation in a container for approximately 30 minutes at room temperature. 125 parts of brominated epoxy resin having a bromine content of 21.5 percent and an epoxy equivalent weight of 520, prepared from the diglycidyl ether of bisphenol-A and a tetrabromobisphenol A dissolved in methylethylketone (MEK) to have 80 percent solids content; 40 parts of dicyandiamide (7.5 percent) dissolved in monomethyl ether of polypropylene glycol (69.9 percent) and dimethylformamide (22.6 percent); and 1 part of 2-methyl imidazole in methanol (10 percent solution).

Prepregs and Electrical Laminates Preparation Procedures Prepregs Preparation

The varnishes of Examples 2 to 5 and 7 to 13 are applied to woven E glass type 7628 available from INTER GLASS by pulling the cloth through a resin bath containing the laminating varnish and then up through a doctor bar set at 0.5 mm to 1.5 mm and then through staged heating zones of an oven with temperatures varying from 140°C to 190°C for Examples 2 to 5 and from 150°C to 170°C for Examples 7 to 13. The total length of heating zone is 3 m. The glass cloth is passed through the resin bath and the heating zones at a rate of 0.8 to 3.2m/min. The parameters of the horizontal treater used are adjusted to produce prepregs with the following characteristics:

| | Test Method | |
|---|---|---|
| Rest gel time at 170°C | 60-120 sec | NEMA LI 1-12.19 |
| Flow at 170°C | 2-25 percent | NEMA LI 1-14.32 |
| Volatiles | < 1 percent | |
| Resin content | 37-44 percent | NEMA LI 1-12.16 |

NEMA refers herein to the National Electrical Manufacturers Association. The above described tests are performed according to the test procedures corresponding to the numbers provided. Such test procedures are available from NEMA which is located 2101 L. Street N.W., Suite 300, Washington DC 20037.

Laminate Preparation

The laminates are obtained from 8 plies of prepreg (15 cm x 15 cm) laid up between two sheets of copper foil and pressed in a laboratory press.

Test Methods

Varnish Properties Measurements

Gel Time Measurement

The gel time of different varnishes is measured by reacting the mixture on the surface of a hot plate at 150°C, 160°C and 170°C. The temperature is calibrated by Signotherm temperature indicators.

Glass Transition Temperature Measurements

The glass transition temperature is measured on film prepared from the varnish formulation used for gel time measurement. The films are cured on a hot plate 170°C for 30 min. Samples are run at 10°C/min. The glass transition temperature is measured by a Mettler TA 2000 DTA at a heating rate of 10°C/min. The inflection point minus 5°C of the endothermic response was taken as the glass transition temperature.

Prepreg Properties Measurements

Gel Time Measurements - Stroke cure

The partially cured resin is removed from the glass fibers, and put on accurately regulated hot plate at 170°C. It is then stroked with a metal wire until gelation occurs. The time from the first contact of the resin with the hot plate to gelation is recorded as the gel time or rest reactivity of the prepreg.

Volatile Determination

A sample of prepreg approximately 10 cm x 10 cm is weighed to the nearest 0.001 gram ($W_1$).
The sample is placed in a circulating air oven at 163°C for 15 minutes and on removal it is placed immediately in a desicator to cool. When cool, the sample is reweighed and the weight recorded as $W_2$. The volatile content is calculated from:

$$\text{percent volatiles} = \frac{(W1 - W2) \times 100}{W1}$$

Resin Content

The resin content is measured by simply weighing an exactly determined surface of prepreg, and comparing with the weight of the same area of glass cloth. The resin content is given by the:

$$\text{(percent)} = \frac{\text{Weight of the Resin content square of prepreg - Weight of the square of glass}}{\text{(Weight of the square of prepreg)}} \times 100$$

Flow Measurement

The flow test indicates the extent of the B-staging and it simulates the behavior of the resin system within the pressing operation. According to NEMA LI 1-14.32 procedure six plies of prepreg of determined size are weighed to the nearest 0.01 gram, stacked together with their edges in careful alignment, fastened together and loaded into the preheated press. The temperature of the press plates is 170°C and pressure is 14 kg/cm$^2$. After 10 minutes the specimen is removed and allowed to cool. Then the flowed resin is removed by cutting and weighing to the nearest 0.01 gram. The resin flow is calculated from the equation:

$$\text{percent flow} = \frac{\text{(Initial weight - weight without flowed resin)}}{\text{Initial weight}} \times 100$$

Flow Measurement

(Prepregs obtained from continuous pressing process)

Six samples, 10 cm x 10 cm are cut in a prepreg sheet and stuck between two copper foils, the shiny copper side facing the prepreg and acting as release sheets. The lab press is heated to 210°C, with a pressure of 30 bars. Pressing time of 1 minute obtains a flow sample. The sample is weighed and a 50 $cm^2$ disk is punched out of the 100 $cm^2$ sample. Flow is given as:

$$\text{percent flow} = \frac{\text{Sample weight - 2 x (disk weight)}}{\text{Initial weight}} \times 100$$

Laminate Testing

Chemical Resistance

To measure the chemical resistance, pieces of etched laminates 5 cm x 5 cm are cut, weighed and dipped for 30 minutes in N-methylpyrrolidone solvent at 23°C. The pieces are dried and then weighed; the pick-up is taken as the gain in weight.

Glass Transition Temperature Measurements

The glass transition temperature of laminates is measured by a Mettler TA 2000 DTA at a heating rate of 10°C/min. The inflection point minus 5°C of the endothermic response is taken as the glass transition temperature.

Moisture Resistance

Twelve pieces of etched laminates 6 cm x 1.5 cm are placed in a pressure cooker during 30, 60, or 90 minutes at 120°C under 1.2 atm. steam. Then, after being dried are dipped (20 seconds) in a tin solder bath (260°C). The moisture absorption is determined by observation from the formation of blisters.

Copper Peel Strength

The binding strength between the copper and the epoxy resin is determined through the strength needed to peel the copper off a laminate. The copper peel strength test is performed according to IPC test Method 2.4.8 Peel Strength, Metal Fort. A 10 cm x 10 cm square of copper foil is laminated to a laminate of the invention. The specimens are tested for peel strength at room temperature. The copper foil is peeled back approximately one inch, so the line of peel is perpendicular to the edge of the specimen. The specimen is clamped on a horizontal surface with the peeled metal strip projecting upward for 1 inch. The end of the foil is gripped between the jaws of the clamp such that the jaws cover the full width of the metal strip and are parallel to the line of peel. Force is exerted in the vertical plane, and the metal foil is pulled at 2 inches per minute. The load is observed and converted to pounds per inch of width. The final peel strength is the average of three tests.

The gel times of varnishes from Examples 1 to 6 are measured. The results are compiled in Table I.

Table A compiles the components of the varnishes prepared in Examples 1 to 11. The epoxy resins are prepared from a diglycidyl ether of bisphenol A, with the exception of Example 3 where bisphenol A is used in place of tetrabromobisphenol A.

In Examples 1, 2, 4-7, 9 and 11 the epoxy resin is added as a solution of 80 percent by weight solids. Dicyanamide is added as a solution of 7.5 percent solids. Boric acid, uncomplexed is added as a 20 percent solids solution in methanol. Uncomplexed 2-MI is added as a solution of 10 percent solids in methanol, in Example 4 the solution has 50 percent solids. In Examples 7-9 the boric acid and 2-MI are added as a complex in methanol 60 percent by weight solids. The weight percent of boric acid in the complex is 26.2 percent, and of 2-MI is 33.4 percent. In Example 10 the catalyst is 2 ethyl-4 methyl imidazole in a 10 percent by weight solution.

TABLE A

| Example | Resin | | Dicyanamide (DICY) | | Boric Acid (BA) | | 2 MI | | Complex | |
|---|---|---|---|---|---|---|---|---|---|---|
| | Parts Sol | Parts resin | Parts Sol | Parts Dicy | Parts Sol | Parts BA | Parts Sol | Parts 2 MI | Yes/ No | Parts |
| 1 | 125 | 100 | 36 | 2.7 | 2.19 | .55 | 4 | 0.4 | no | |
| 2 | 125 | 100 | 40 | 3.0 | 1.65 | .33 | 3.5 | .35 | no | |
| 3 | - | 95 | 39.2 | 2.6 | 1.57 | .31 | 3.8 | .38 | no | |
| 4 | 125 | 100 | 40 | 3.0 | 4.5 | .9 | 1.6 | .8 | no | |
| 5* | 125 | 100 | 40 | 3.0 | - | - | 1 | .1 | no | |
| 6* | 125 | 100 | 40 | 3.0 | | | 2.5 | .25 | no | |
| 7 | 125 | 100 | 40 | 3.0 | - | .44 | - | .56 | yes | 1.67 |
| 8 | | 95 | 38 | 2.85 | - | .37 | - | .48 | yes | 1.425 |
| 9 | 125 | 100 | 40 | 3.0 | - | .83 | - | 1.06 | yes | 3.17 |
| 10* | 100 | 90 | 40.8 | 3.06 | - | - | 5.4 | .54 | no | |
| 11* | 125 | 100 | 40 | 3.0 | - | - | 1.0 | .1 | no | |

* Not an example of the invention

TABLE I

| GEL TIMES OF DIFFERENT VARNISHES AT DIFFERENT TEMPERATURES | | | | |
|---|---|---|---|---|
| Examples | Gel Time at 150°C (sec) | Gel time at 160°C (sec) | Gel time at 170°C (sec) | Tg * °C |
| 1 | 445 | 319 | 203 | 150 |
| 2 | 390 | 271 | 172 | 148 |
| 3 | 310 | 220 | 140 | 148 |
| 4 | 353 | 240 | 161 | 152 |
| 5** | 362 | 245 | 171 | 125 |
| 6** | 194 | 133 | 88 | 134 |

* The glass transition temperatures are measured on films obtained by curing the different varnishes at 170°C for 30 min.

** Not an example of the invention.

Laminate Preparation and Testing

Laminates are prepared using varnishes from Examples 2, 3, 4, 5. The properties of such laminates are determined using the procedures described hereinbefore. The prepregs obtained from varnishes from Examples 2 to 4 are pressed for 40 min in the press at 165°C (10 min heating from room temperature to 165°C and 30 minutes at 165°C) with controlled pressures to obtain laminate thickness of 1.3 to 1.6 mm. A prepreg prepared using a second sample of a varnish from Example 4 is pressed at 200°C for 5 minutes at 30 kg/cm$^2$. Laminates from Example 5 are prepared using the following press cycle.

| | | Pressure (kg/cm$^2$) | Time (min) |
|---|---|---|---|
| 1. | Room temperature to 170°C | 14 | 30 |
| 2. | Keep at 170°C | 40 | 90 |
| 3. | Cool to room temperature | 40 | 15 |

The results are compiled in Table II.

TABLE II

| FR-4 RESIN FORMULATIONS, VARNISHES, PREPREGS AND LAMINATES PROPERTIES | | | | | |
|---|---|---|---|---|---|
| Example | 2 | 3 | 4 | | 5* |
| | | | I | II | |
| TREATER SETTING | | | | | |
| Oven temp.zones 1/2(°C) | 148/183 | 150/190 | 150/171 | 154/182 | 150/170 |
| Winding speed (m/min) | 1.5 | 3 | 0.85 | 2 | 2.6 |
| VARNISH PROPERTIES | | | | | |
| Gel time 170°C (sec) | 172 | 140 | 161 | 161 | 171 |
| Viscosity (Ford Cup No 4, sec) | 28 | 27 | 40 | 40 | 44 |
| PREPREG PROPERTIES | | | | | |
| % Resin content | 40.7 | 39 | 46.5 | 44 | 37.5 |
| % Volatiles | 0.2 | 0.2 | 0.2 | 0.2 | 0.2 |
| Rest gel time, 170°C (sec) | 66 | 54 | - | 65 | 140 |
| % Flow | 11.2 | 13.8 | 6.6 | 18 | 25.7 |
| Appearance | good | excell. | good | good | good |
| LAMINATE PROPERTIES | | | | | |
| Tg (°C) | 143 | 142 | 148 | 152 | 127 |
| Chemical Resistance (% NMP pick-up) | 0.6 | 0.2 | 0.4 | 0.3 | 0.5 |
| Blister Resistance (PCT MIN) | 60 | 60 | - | - | 60 |
| Copper Peel Strength (N/cm) | 18 | 18 | 17 | 18 | 21 |

* Not an example of the invention

Laminates prepared from varnishes of Examples 7-11 are tested for properties as described hereinbefore. The properties are compiled in Table III.

The prepregs obtained from varnishes Examples 7 and 11 are pressed for 15, 30, 60 and 90 min in the press at 165°C. The prepregs obtained from Examples 9 and 10 are pressed at 210°C for 2 and 3 mins. The pressure of the press is set at 40 kg/$cm^2$ continuous press cycle.

TABLE III

| FR-4 RESIN FORMULATIONS, VARNISHES, PREPREG AND LAMINATES PROPERTIES | | | |
|---|---|---|---|
| Example | 7 | 8 | 11* |
| VARNISH PROPERTIES | | | |
| Gel time 170°C (sec) | 147 | 119 | 300 |

* Not an example of the invention

TABLE III (continued)

| FR-4 RESIN FORMULATIONS, VARNISHES, PREPREG AND LAMINATES PROPERTIES | | | |
|---|---|---|---|
| Example | 7 | 8 | 11* |
| VARNISH PROPERTIES | | | |
| Viscosity (Ford Cup No 4, sec) | 29 | 20 | 21 |
| PREPREG PROPERTIES | | | |
| % Resin content | 43 | 41 | 40 |
| % Volatiles | 0.17 | 0.26 | - |
| Rest gel time, 170°C (sec) | 60 | 104 | 139 |
| % Flow | 14.3 | 21.6 | 11.8 |
| Appearance | good | good | good |
| LAMINATE PROPERTIES | | | |
| (obtained from 30 min at 165°C) Tg (deg C) | 142 | 142 | 122 |
| Chemical resistance (% NMP pick-up) | 0.2 | 0.2 | 3.3 |
| Blister resistance (PCT MIN) | 30 | 30 | 30 |
| Copper peel strength (N/cm) | 17.2 | 17 | 20 |

* Not an example of the invention

Laminates are prepared from Examples 9,10. The properties of the varnishes, prepreg and laminates are compiled in Table III A.

TABLE III A

| FR-4 RESIN FORMULATIONS FOR CONTINUOUS PRESSING TECHNOLOGY - CURED RESINS, PREPREGS AND LAMINATES PROPERTIES | | |
|---|---|---|
| Example | 9 | 10 |
| VARNISH PROPERTIES | | |
| Gel time 170°C (sec) | 91 | 106 |
| Viscosity (Ford Cup No 4, sec) | 28 | 19 |
| PREPREG PROPERTIES | | |
| % Resin content | 40.7 | 42 |
| % Volatiles | 0.1 | 0.1 |
| % Flow | 4.5 | 3.5 |
| Appearance | good | good |
| LAMINATE PROPERTIES | | |
| (obtained from 2 and 3 min at 210°C) Tg (deg C I/II)** | | |

** The Tg is determined twice for the same sample and both values are reported. The second determination is made after the sample is cooled from the previous test.

TABLE III A (continued)

| FR-4 RESIN FORMULATIONS FOR CONTINUOUS PRESSING TECHNOLOGY - CURED RESINS, PREPREGS AND LAMINATES PROPERTIES | | |
|---|---|---|
| Example | 9 | 10 |
| LAMINATE PROPERTIES | | |
| 2 min | 145/145 | 136/136 |
| 3 min | 146/147 | 136/135 |
| Chemical resistance (% NMP pick-up) | | |
| 2 min | 0.1 | 0.5 |
| 3 min | 0.05 | 0.5 |
| Copper peel strength (N/cm) | 17 | 18 |

The glass transition temperature and solvent resistance of laminates from varnishes of Example 7 and 11 are measured. Results compiled in Table IV.

TABLE IV

| GLASS TRANSITION TEMPERATURE AND SOLVENT RESISTANCE MEASURED FROM LAMINATES OF EXAMPLES 7 AND 11 | | | | | |
|---|---|---|---|---|---|
| Press Time (min | | 15 | 30 | 60 | 90 |
| 7 | Tg(°C) | 125 | 142 | 145 | 146 |
| | % NMP pick-up | 0.3 | 0.16 | 0.16 | 0.15 |
| 11* | Tg(°C) | 107 | 122 | 123 | 124 |
| | % NMP pick-up | 4.4 | 3.3 | 2.5 | 2.4 |

* Not an example of the invention

The top number is the glass transition temperature. The bottom number is the percent weight gain when exposed to N-methyl pyrrolidone (NMP).

TABLE V -

| COMPARISON OF TREATER PARAMETERS AND PREPREG PROPERTIES FOR EXAMPLES 7,8 AND 5 | | | | | | |
|---|---|---|---|---|---|---|
| Examples | 7 | | 8 | | 5* | |
| VARNISH GEL TIME (170°C, sec) | 147 | | 119 | | 171 | |
| OVEN TEMP. (recorded) | | | | | | |
| Zone 1 (deg C) | 150 | | 145 | | 150 | |
| Zone 2 (deg C) | 170 | | 165 | | 170 | |
| GAP (mm) | 0.6 | 0.6 | 1 | 1 | 0.75 | 0.65 |
| WINDING SPEED (m/min) | 2.5 | 2.8 | 2.6 | 3 | 2.3 | 2.6 |
| PREPREG PROP. Resin content (%) | 39.8 | 42.1 | 41.2 | 43.0 | 39.5 | 37.5 |
| Rest gel time at 170°C (sec) | 102 | 126 | 104 | 108 | 116 | 140 |

* Not an Example of the Invention.

TABLE V - (continued)

| COMPARISON OF TREATER PARAMETERS AND PREPREG PROPERTIES FOR EXAMPLES 7,8 AND 5 | | | | | | |
|---|---|---|---|---|---|---|
| Examples | 7 | | 8 | | 5* | |
| Flow(%) | 16.7 | 18.3 | 21.6 | 23 | 17.6 | 25.7 |
| Appearance | good | good | good | good | good | good |

* Not an Example of the Invention.

Films, prepregs and laminates prepared from varnishes of Examples 1 to 11 demonstrate that resin compositions of the invention prepare cured and partially cured products having significantly higher glass transition temperatures than resin compositions not within the scope of the invention.

Example 12

An isocyanate modified epoxy resin is prepared by the process described below from the following components; 400 parts of a polyglycidyl ether of 2,2-bis(4-hydroxy-phenyl) propane (bisphenol A) having an epoxide equivalent weight of about 180; 260 parts of brominated epoxy resin with bromine content of 49 percent prepared from the diglycidyl ether of 2,2-bis(4-hydroxy-3,5 dibromo-phenyl) propane (tetrabromobisphenol A) and 2,2-bis(4-hydroxy-3,5-dibromo-phenyl) propane (tetrabromobisphenol A); 0.6 parts 2-phenyl imidazole dissolved in an equal amount of methanol; 90 parts methylene diphenyl diisocyanate (available from The Dow Chemical Company under the trademark Voranate* M 220) and 250 parts of methylethylketone. The resin is prepared by the following procedure.

The liquid epoxy resin and brominated epoxy resin are charged to a reactor. The mixture is stirred and heated under a nitrogen atmosphere to about 90°C. The catalyst of 2-phenyl imidazole is added to the mixture once it reaches 90°C. The mixture is heated to 150°C. Methylenediphenyl diisocyanate is added over a period of 30 to 45 minutes. The reaction temperature is maintained between 155 and 175°C during the addition. The mixture is heated on addition 30 minutes. A portion is removed and titrated to determine the epoxy content. It is determined to be 12 percent. The mixture is cooled to 130°C and methylethylketone is added.

133.33 parts of the isocyanate modified epoxy resin solution is blended with 2.5 parts of a boric acid in methanol solution (20 percent) (0.5 phr boric acid); 42.66 parts of dicyandiamide (7.5 percent) in monomethyl ether of propylene glycol (69.9 percent) and dimethylformamide (22.6 percent) solution, (3.2 phr); and a 1.1 parts of 50 percent 2-methyl imidazole in methanol (0.55 phr), at room temperature for 30 minutes.

Example 13 - Not an Example of the invention

133.33 parts of the isocyanate modified epoxy resin prepared as in Example 12 are blended with, 42.66 parts of a dicyandiamide (7.5 percent) in monoethylether of propylene glycol (69.9 percent) and dimethylformamide (22.6 percent) solution and 0.18 parts of 50 percent 2-methyl imidazole in methanol (0.09 phr) at room temperature for 30 minutes.

Prepregs and laminates are prepared using the varnishes of Examples 12 and 13. The properties of the varnishes, prepregs, and laminates are determined by the processes described above. The results are compiled in Table VI.

Table VI

| | Example 12 | Example 13* |
|---|---|---|
| VARNISH PROPERTIES | | |
| Gel time (170°C) sec | 191 | 253 |
| Viscosity (Ford cup No.4, sec) | 28 | 30 |
| Treating parameter | 154/174 | 150/178 |
| Oven temp. (Zone 1/2, C°) | | |
| Winding speed (m/min) | 2.1 | 1.8 |
| PREPREG PROPERTIES | | |
| Resin Content (%) | 44 | 43 |
| Gel Time (170°C, sec) | 70 | 115 |
| Flow (%) | 16.5 | ---- |
| LAMINATE PROPERTIES | | |
| (45 min at 175°C) | | |
| Tg (°C I/II)** | 179/182 | 155/165 |
| NMP pick-up (%) | 0.11 | 0.18 |

* Not an example of the invention

** The Tg is determined twice for the same sample and both values are reported. The second determination is made after the sample is cooled from the previous test.

Examples 12 and 13 show that laminates prepared from epoxy resin compositions of this invention demonstrate better glass transition temperatures than those not within the scope of the claims. The gel time of Example 13 is greater than the gel time of Example 12 while the catalyst level of Example 13 is 0.09 phr and the catalyst level of Example 12 is 0.55 phr.

Example 14 to 19

Varnishes are prepared by blending an 125 parts of a brominated epoxy resin having a bromine content of 20 percent and an epoxy equivalent weight of 418, prepared from the diglycidyl ether of bisphenol A and tetrabromobisphenol A dissolved in methylethylketone (80 percent solids); 40 parts of a solution of dicyandiamide (7.5 percent) in monomethyl ether of propylene glycol (69.9 percent) and dimethylformamide (22.6 percent), (3 phr); a catalyst and in Examples 15, 17 and 19 boric acid. The relative amounts of catalyst and boric acid are compiled in Table VII. The gel time and glass transition temperature are measured of films cured at 170°C for 30, and 60 minutes prepared from the varnishes. The results are compiled in Table VII.

Table VII

| Exam ple | Catalyst | phr | Boric-acid phr | Varnish | | | Glass Transition °C | |
|---|---|---|---|---|---|---|---|---|
| | | | | 150 °C | 160 °C | 170 °C | 30 min | 60 min |
| 14* | Ethyltriphenyl phosphonium acetate.Acetic acid complex | 0.2 | 0 | -- | -- | 307 | -- | 131 |
| 15 | Ethyltriphenyl phosphonium acetate.Acetic acid complex | 1.0 | 0.524 | -- | -- | 391 | -- | 140 |
| 16* | butyl dimethyl amine | 0.2 | 0 | 366 | 299 | 240 | 130 | 138 |
| 17 | butyl dimethyl amine | 1.0 | 0.524 | -- | 347 | 245 | 136 | 143 |
| 18* | Diisobutyl amine | 0.2 | -- | -- | -- | 510 | -- | -- |
| 19 | Diisobutyl amine | 1.0 | 0.524 | -- | -- | > 780 | -- | -- |

* Not an example of the invention

Examples 20-40

Varnishes are prepared from three different resins using varying amounts of curing agent, dicyandiamide; inhibitor, boric acid; and catalyst, 2-methyl imidazole. Resin A is brominated epoxy resin having a bromine content of 20 percent and an epoxy equivalent weight of 418, prepared from the diglycidyl ether of bisphenol A and tetrabromobisphenol A dissolved in methylethylketone (80 percent solids).

Resin B is brominated epoxy resin with a bromine content of 19 percent and an epoxy equivalent weight of 395 prepared from the diglycidyl ether of bisphenol A and tetrabromobisphenol A in methylethylketone 80 percent solids.

Resin C is a brominated epoxy resin having a bromine content of 20 percent and an epoxy equivalent weight of 430, prepared from the diglycidyl ether of bisphenol A and tetrabromobisphenol A dissolved in methylethylketone (80 percent solids content).

The resin solutions are blended with dicyandiamide (7.5 percent) in monomethyl ether of propylene glycol (69.9 percent) and dimethylformamide (22.6 percent); boric acid in methanol (20 percent boric acid); and 2-methyl imidazole in methanol (10 percent 2-methyl imidazole); at ambient temperature with agitation for about 30 minutes. The gel time of each varnish is determined at 150°C, 160°C and 170°C. A film is prepared from each resin, which is cured for 30 minutes at 170°C, the films from Examples 33 to 38 are cured for 60 minutes. The glass transition temperature of the films are determined. The results are compiled in Table VIII.

Table VIII

| Example | Resin | Curing Agent phr | Boric Acid phr | Catalyst phr | Gel Time (sec) | | | Tg °C |
|---|---|---|---|---|---|---|---|---|
| | | | | | 150 °C | 160 °C | 170 °C | |
| 20 | A | 3 | 0.33 | 0.2 | 1086 | 484 | 303 | 134 |
| 21 | A | 3 | 0.33 | 0.3 | 532 | 340 | 212 | 148 |
| 22 | A | 3 | 0.33 | 0.4 | 353 | 232 | 152 | 148 |
| 23 | A | 3 | 0.33 | 0.5 | 250 | 163 | 100 | 153 |
| 24 | A | 2.7 | 0.437 | 0.3 | 662 | 454 | 278 | 137 |
| 25 | A | 2.7 | 0.437 | 0.4 | 445 | 319 | 203 | 149 |
| 26 | A | 2.7 | 0.437 | 0.5 | 288 | 230 | 141 | 146 |
| 27 | A | 2.7 | 0.437 | 0.6 | 221 | 170 | 91 | 153 |
| 28 | A | 2.7 | 0.524 | 0.3 | 751 | 508 | 339 | 147 |
| 29 | A | 2.7 | 0.524 | 0.4 | 528 | 390 | 256 | 147 |
| 30 | A | 2.7 | 0.524 | 0.5 | 386 | 274 | 164 | 148 |
| 31 | A | 2.7 | 0.524 | 0.6 | 283 | 200 | 132 | 158 |
| 32 | B | 2.7 | 0.65 | 0.6 | 319 | -- | 158 | 153** |
| 33 | B | 2.7 | 0.75 | 0.65 | 292 | -- | 156 | 157** |
| 34 | B | 2.7 | 0.7 | 0.65 | 286 | -- | 142 | 149** |
| 35 | C | 2.7 | 0.65 | 0.6 | 347 | -- | 165 | 156** |
| 36 | C | 2.7 | 0.75 | 0.65 | 313 | -- | 155 | 157** |
| 37 | C | 2.7 | 0.7 | 0.65 | 293 | -- | 148 | 152** |
| 38 | C | 2.7 | 0.8 | 0.8 | 205 | 162 | 100 | 154 |
| 39 | C | 3 | 0.25 | 0.3 | 342 | 234 | 165 | 147 |
| 40 | C | 3 | 0.25 | 0.4 | 233 | 163 | 98 | 144 |

** 60 min resident time at 170 °C

Example 41

A varnish comprising 125 parts of resin B, 37.33 parts of a dicyandiamide (7.5 percent) in monomethyl ether of propylene glycol (69.9 percent) and dimethylformamide (22.6 percent); 2.5 parts of boric acid (20 percent) in methanol; and 1.1 parts of 2 methyl imidazole (50 percent) in methanol is prepared, as described in Example 1. The Gel time of the varnish is measured at 150 and 170°C periodically over a eleven day period. The results are compiled in Table IX.

Table IX

| Varnish Storage Stability at Room Temperature | | | | | |
|---|---|---|---|---|---|
| No. of Days | 0 | 3 | 4 | 5 | 11 |
| Gel Time at 150°C (sec) | 386 | 381 | -- | 387 | 386 |
| Gel Time at 170°C (sec) | 164 | 173 | 171 | 173 | 172 |

Example 41 shows a composition of this invention is stable for 11 days.

Examples 42 to 48

Varnishes are prepared by blending a 125 parts of a brominated epoxy resin having a bromine content of 20 percent and an epoxy equivalent weight of 418, prepared from the diglycidyl ether of bisphenol A and tetrabromobisphenol A, dissolved in methylethylketone (80 percent solids); 40 parts of a solution of dicyandiamide (7.5 percent) in monomethyl ether of propylene glycol (69.9 percent) and dimethylformamide (22.6 percent), (3 phr); a catalyst (pyridine or triphenyl phosphine) and in Examples 44 and 47 an inhibitor of boric acid. The gel time is measured. The relative amounts of catalyst and boric acid and results are compiled in Table X.

Table X

| Example | Catalyst | phr | Boric Acid phr | Gel Time at 170°(sec) |
|---|---|---|---|---|
| 42* | Pyridine | 0.2 | - | 361 |
| 43* | Pyridine | 0.4 | - | 308 |
| 44 | Pyridine | 1.1 | 1 | 319 |
| 45* | Pyridine | 1.5 | - | 223 |
| 46* | Triphenyl phosphine | 0.2 | - | 395 |
| 47 | Triphenyl phosphine | 1.5 | 1 | 354 |
| 48* | Triphenyl phosphine | 1.5 | - | 202 |

* Not an example of the invention

Examples 49 to 90

Varnishes with different levels of catalyst, curing agent, and inhibitor are prepared by the following procedure. The stroke cure rate, gel time, and the glass transition temperature are determined. The amounts of components, gel times and glass transition temperatures are compiled in Table XI.

A 20 percent solution of boric acid in methanol is added to a brominated epoxy resin prepared by advancing the diglycidyl ether of bisphenol A with tetrabromobisphenol A to 4.7 to 5.0 percent epoxide, then back blending with diglycidyl ether of bisphenol A to a 9.8 to 10.1 percent epoxide, the final product is diluted to 80 percent solids in acetone. The mixture is stirred till homogeneous, then allowed to stand for different time intervals at ambient temperature. To this solution is added a 10 percent solution of dicyandiamide (10 percent by weight dicyandiamide in a 50/50

mixture of dimethyl formamide and monomethyl ether of propylene glycol stirred till homogeneous), then a 40 percent solution of 2-methyl imidazole in methanol is added and stirred till homogeneous. This solution is then allowed to stand at ambient temperature 2 hours before gel times or cured products are made.

Gel time is determined via a stroke-cure procedure at 175°C. Glass transition temperatures were determined via differential scanning calorimetry (DSC) at a heating rate of 10°C per minute, using the mid-point of the transition.

Table XI

| Example | Boric acid (phr) | 2-methylimidazole (phr) | Dicyandiamide (phr) | Gel Time (sec) (sec) | Tg (°C) | Stand time (hrs) |
|---|---|---|---|---|---|---|
| 49 | 0.4 | 0.35 | 2.5 | 246* | 146 | 24 |
| 50 | 0.4 | 0.35 | 3 | 246* | 145 | 24 |
| 51 | 0.4 | 0.75 | 3 | 87.5* | 135 | 24 |
| 52 | 0.4 | 0.75 | 2.5 | 86.5* | 140 | 24 |
| 53 | 0.8 | 0.75 | 2.5 | 186* | 143 | 24 |
| 54 | 0.8 | 0.75 | 3 | 181.5 | 142 | 24 |
| 55 | 0.8 | 0.35 | 3 | 288 | 148 | 24 |
| 56 | 0.8 | 0.35 | 2.5 | 349.5 | 154 | 24 |
| 57 | 0.6 | 0.55 | 2.75 | 189.5 | 149 | 24 |
| 58 | 0.6 | 0.55 | 2.75 | 197 | 148 | 24 |
| 59 | 0.6 | 0.55 | 2.75 | 190 | 140 | 0 |
| 60 | 0.6 | 0.55 | 2.75 | 214 | 144 | 1.5 |
| 61 | 0.6 | 0.55 | 2.75 | 232 | 149 | 24 |
| 62 | 0.6 | 0.55 | 2.75 | 232 | 150 | 12 |
| 63 | 1.01 | 0.55 | 2.75 | 278 | 156 | 1.5 |
| 64 | 1.51 | 0.55 | 2.75 | 270 | 158 | 1.5 |
| 65 | 1.01 | 0.55 | 2.75 | 270 | 157 | 24 |
| 66 | 1.51 | 0.55 | 2.75 | 268 | 161 | 24 |
| 67 | 1.01 | 0.55 | 2.75 | 273 | 154 | 12 |
| 68 | 1.51 | 0.55 | 2.75 | 270 | --- | 12 |
| 69 | 1.01 | 0.35 | 2.5 | --- | 157 | 15 |
| 70 | 1.51 | 0.35 | 2.5 | --- | 162 | 15 |
| 71 | 0.6 | 0.55 | 2.75 | 230 | 153 | 0 |
| 72 | 0.6 | 0.55 | 2.75 | 205 | 153 | 1 |
| 73 | 0.6 | 0.55 | 2.75 | 199 | 146 | 2 |
| 74 | 0.6 | 0.55 | 2.75 | 201 | 149 | 3 |
| 75 | 0.6 | 0.55 | 2.75 | 202 | --- | 6 |
| 76 | 0.2 | 0.175 | 2 | 353 | 140 | 2 |
| 77 | 0.2 | 0.175 | 2.5 | 349 | 147 | 12-16 |
| 78 | 0.2 | 0.35 | 2.5 | 140 | 138 | 12-16 |
| 79 | 0.2 | 0.35 | 2 | 162 | 142 | 12-16 |
| 80 | 0.4 | 0.35 | 2 | 298 | 151 | 12-16 |

* Stroke time for Examples 48-58 are the average of two samples

Table XI (continued)

| Example | Boric acid (phr) | 2-methylimidazole (phr) | Dicyandiamide (phr) | Gel Time (sec) (sec) | Tg (°C) | Stand time (hrs) |
|---|---|---|---|---|---|---|
| 81 | 0.4 | 0.35 | 2.5 | 260 | 149 | 12-16 |
| 82 | 0.4 | 0.175 | 2.5 | 451 | 150 | 12-16 |
| 83 | 0.4 | 0.175 | 2 | 571 | 140 | 12-16 |
| 84 | 0.3 | 0.2625 | 2.25 | 290 | --- | 12-16 |
| 85 | 0.3 | 0.2625 | 2.25 | 284 | 149 | 12-16 |
| 86 | 0.8 | 0.175 | 2 | 583 | 148 | 12-16 |
| 87 | 0.8 | 0.175 | 2.5 | 485 | 149 | 12-16 |
| 88 | 0.8 | 0.35 | 2.5 | 360 | 153 | 12-16 |
| 89 | 0.8 | 0.35 | 2 | 433 | 153 | 12-16 |
| 90 | 1.4 | 0.263 | 2.25 | 232 | 154 | 12-16 |
| 91 | 1.4 | 0.263 | 2.25 | 230 | 155 | 12-16 |

Examples 92 - 102

The following components are employed in the Examples 92-102.

Solution A

One mole of 2-methylimidazole is mixed with 1.03 moles of aqueous fluoroboric acid in the presence of a sufficient quantity of methanol such that the weight of 2-methylimidazole and solid fluoroboric acid is 40 to 50 percent by weight of the total mixture.

Solution B

One mole of 2-methylimidazole is mixed with 1.03 moles of boric acid in the presence of an amount of water approximately equal to the weight of the boric acid and a sufficient amount of methanol such that the weight of 2-methylimidazole and boric acid is 40 to 50 percent by weight of the total mixture.

Catalyst Preparation

The catalysts used in the following Examples use either Solution A or B, or blends thereof. Alternately, the catalysts are prepared by adding, either a mixture or separately, fluoboric acid and boric acid to 2-methylimidazole and diluting the resulting mixture with methanol to 40 percent to 50 percent solids based on the three components. It is generally preferable to digest the resulting mixtures for 16 to 24 hours at 50°C to 60°C before use.

CATALYST A-1 Solution A, this catalyst is used immediately after mixing.

CATALYST A-2 Solution A, this catalyst is stored in an oven at 60°C for 24-hours before using.

CATALYST 1 Solution B, this catalyst is used immediately after mixing.

CATALYST 1-A Solution B, this catalyst is stored in an oven at 60°C for 24-hours before using.

CATALYST 2 A quantity of Solution A sufficient to give 0.2 moles of 2-methylimidazole is mixed with a quantity of Solution B sufficient to give 0.1 moles of 2-methylimidazole. This catalyst is used immediately after mixing.

CATALYST 2-A A quantity of Solution A sufficient to give 0.2 moles of 2-methylimidazole is mixed with a quantity

of Solution B sufficient to give 0.1 moles of 2-methylimidazole. This combined solution is then stored in an oven at 60°C for 24-hours before using.

CATALYST 3 A quantity of Solution A sufficient to give 0.2 moles of 2-methylimidazole is mixed with a quantity of Solution B sufficient to give 0.2 moles of 2-methylimidazole. This catalyst is used immediately after mixing.

CATALYST 3-A A quantity of Solution A sufficient to give 0.2 moles of 2-methylimidazole is mixed with a quantity of Solution B sufficient to give 0.2 moles of 2-methylimidazole. This combined solution is then stored in an oven at 60°C for 24-hours before using.

CATALYST 4 A quantity of Solution A sufficient to give 0.1 moles of 2-methylimidazole is mixed with a quantity of Solution B sufficient to give 0.1 moles of 2-methylimidazole. This catalyst is used immediately after mixing.

CATALYST 5 A quantity of Solution A sufficient to give 0.1 moles of 2-methylimidazole is mixed with a quantity of Solution B sufficient to give 0.2 moles of 2-methylimidazole. This catalyst is used immediately after mixing.

Examples 92 -97

Viscosity Stability

To an 80 percent solution by weight in propylene glycol monomethylether acetate of (1) the diglycidyl ether of bisphenol A having an epoxide equivalent weight of 181.5 and (2) the para, para isomer of bisphenol A mixed at a molar ratio of 0.98 mole of bisphenol A per mole of epoxy, are added portions of the above catalyst solutions sufficient to give a molar ratio of 2-methylimidazole to epoxy of 3 to 9 millimoles per mole as shown in Table XII. The initial viscosity measured at 25°C is recorded.

A portion of the samples are then stored in an oven at 50°C. Periodically samples are removed and the viscosity, measured at 25°C, is recorded. The viscosity data and percent increase in viscosity relative to the second day is recorded in Table XII.

Reactivity

The relative reactivity of these catalysts for promoting the reaction of an epoxy with a phenolic compound is obtained by blending the catalysts with an epoxy and bisphenol as described above, but without a solvent. The bisphenol is dissolved in the epoxy by heating to approximately 100°C to 150°C, then cooled to approximately 60°C and the catalyst added and stirred until homogeneous. The change in viscosity with time at 150°C is then recorded. The period before a notable change in viscosity is observed is recorded in Table XIII, as the induction time. The slope of the the line obtained from plotting the log of viscosity vs time is recorded in Table XIII, as the relative rate of reactivity.

Table XII

| | Ex. 92 | Ex. 93 |
|---|---|---|
| Catalyst | | |
| Type | 2 | 3 |
| Amount[a] | 3 | 3 |
| Init. Visc. | | |
| cps | 1583 | 1558 |
| Pa·s | 1.583 | 1.558 |
| 1 Day Visc. | | |
| cps | 1740 | 1760 |
| Pa·s | 1.740 | 1.760 |

a milliequivalents of catalyst per equivalent of epoxide.

Table XII (continued)

| | Ex. 92 | Ex. 93 |
|---|---|---|
| 1 Day Visc. | | |
| % Incr.[c] | 10 | 13 |
| 5 Day Visc. | | |
| cps<br>Pa·s<br>% Incr. | 2202<br>2.202<br>27 | 2443<br>2.443<br>39 |
| 7 Day Visc. | | |
| cps<br>Pa.s<br>% Incr. | 2423<br>2.423<br>39 | 3391<br>3.391<br>93 |
| 12 Day Visc. | | |
| cps<br>Pa.s<br>% Incr.[b] | 3495<br>3.495<br>101 | 7058<br>7.058<br>301 |

b rounded to the nearest

Table XIII

| Ex. No. | Catalyst | | Induction Time Minutes | Relative Reaction Rate |
|---|---|---|---|---|
| | Type | Amt.[a] | | |
| 92 | 2 | 3 | 21 | 68 |
| 93 | 3 | 3 | 19 | 67 |
| 94 | 1-A | 3 | ND[b] | ND[b] |
| 95 | 2-A | 3 | 17 | 76 |
| 96 | 5 | 9 | 8 | 130 |
| 97 | 3-A | 3 | 15 | 81 |
| 98 | A-1 | 9 | 85 | 42 |
| 99 | 1 | 4.5 | 10 | 84 |
| 100 | 1 | 9 | 5 | 240 |
| 101 | 2 | 9 | 20 | 68 |
| 102 | 3 | 9 | 20 | 67 |

a Milliequivalents of catalyst per equivalent of epoxide.
b Not determined.

Examples 103 - 109

The varnishes of Examples 103-109 are prepared by blending a 80 percent solution of a brominated epoxy resin, prepared by the reaction of the diglycidyl ether of bisphenol-A with tetrabromobisphenol-A and having an epoxide equivalent weight of 445, in methyl ethyl ketone, either a 10 percent or a 20 percent solution of boric acid (BA) in different solvents, a 7.5 percent solution of dicyandiamide dissolved in 1-methoxy-2-propanol (69.9 percent) and dimethylformamide (22.6 percent), and a 10 percent solution of 2-methyl imidazole (2-MI) in methanol. The resin solution is first blended with the boric acid solution for approximately 2 hours at room temperature until a homogeneous solution is obtained. Dicyandiamide solution followed by 2-MI solution are then added and mixed for approximately 2

hours prior to testing. The gel time of each varnish is determined on the heated surface of a hot plate controlled at 170°C and the resulting film is cured on the hot plate for a period of 30 minutes. The glass transition temperatures and gel times are reported in Table XIV. The compositions contain the following amounts of reactive components: resin solution 125 parts, dicyandiamide 2.8 phr, boric acid (BA) 0.4 phr, 2-methylimidazole 0.45 phr.

Table XIV

| Exam ple | Solvent for Boric acid | Geltime 170°C sec ageing days | | | Tg Film, °C cure 30 min 170°C | Solvent BP°C |
|---|---|---|---|---|---|---|
| | | 0 | 3 | 4 | | |
| 103 | 1,2 propanediol(10 % BA) | 206 | 212 | 213 | 145 | 187 |
| 104 | diethyleneglycol (20 % BA) | 197 | 198 | 193 | 149 | 245 |
| 105 | ethyleneglycol (20 % BA) | 206 | 206 | 213 | 147 | 197 |
| 106 | N-methylpryrrolidone (10 % BA) | 195 | 197 | - | 148 | 202 |
| 107 | methanol (20 % BA) | 183 | 188 | 186 | 150 | 65 |
| 108 | glycerine (20 % BA) | 301 | 303 | - | 144 | 290 |
| 109 | DMSO (20 % BA) | 184 | 185 | 186 | 150 | 189 |

Examples 110 - 115

The varnishes of Examples 110 - 115 are prepared according to the method described in Examples 102-108 except N-benzyldimethyl amine (BDMA) is used as accelerator for the systems instead of 2-methylimidazole. The composition contains the following reactive components, resin solution 125 parts, boric acid (BA) 0.4 phr, dicyandiamide 2.7 phr, BDMA 0.8 phr. The results of gel time and glass transition testing are compiled in Table XV.

Table XV

| Exam ple | Solvent for Boric acid | Geltime 170°C sec ageing days | | Tg Film, C curing on 60 min 170°C |
|---|---|---|---|---|
| | | 2 hrs | 24 hrs | |
| 110 | 1,2 propanediol (10 % BA) | 370 | 337 | 136 |
| 111 | diethyleneglycol (10 % BA) | 337 | 283 | 139 |
| 112 | ethyleneglycol (20 % BA) | 362 | 320 | 135 |
| 113 | glycerine (20 % BA) | 483 | 441 | 133 |
| 114 | DMSO (20 % BA) | 338 | 289 | 139 |
| 115 | Methanol (20 % BA) | 332 | 275 | 139 |

Examples 116 - 120

The varnishes of Examples 116-120 are prepared by mixing and blending the following three solutions by simple agitation in a container for approximately 2 hours. A first solution which contains a glycidyl polyether of 2,2-bis (4-hydroxyphenyl) propane having an average molecular weight of about 350 and an epoxide equivalent weight of about 180, 38 parts, tetrabromobisphenol-A, 25.9 parts, phenolic novolac, obtained from S.I.R. under the trade name Sirfen 0-1100 and methyl ethyl ketone, 25 parts, is prepared by blending and mixing the components at a temperature of from 50 to 60°C until a homogeneous solution is obtained (approximately 2 hours). The second solution is 10 percent boric acid methanol. The third solution is 2MI 10 percent 2-methylimidazole in methanol.

The resin solution is first blended with the boric acid solution for approximately 2 hours at room temperature. 2-MI solution is then added and mixed for approximately 2 hours prior to testing. The gel time of each varnish is

determinated on the heated surface of a hot plate controlled at 170°C and the resulting film is cured on the hot plate for a period of 90 minutes. The result are reported on Table XVII.

Table XVII

| Example | Boric acid phr | 2-MI phr | Gel time 170; sec | Tg °C |
|---|---|---|---|---|
| 116* | 0 | 0,1 | 234 | 136 |
| 117 | 0,6 | 0,1 | 348 | 141 |
| 118* | 0 | 0,2 | 126 | 143 |
| 119** | 0,2 | 0,2 | 153 | - |
| 120 | 0,6 | 0,2 | 169 | 146 |

*Examples 116 and 118 are comparative examples

** Resin solution (1) is first blended with boric acid solution and aged in an oven at 60°C for a period of 5 days. The aged solution is blended with 2-MI solution at room temperature for approximately 2 hours.

Examples 116-120 demonstrate for a phenolic cure system that increases in boric acid result in longer gel times without significant effects on the glass transition temperature of the cured films.

Examples 121 - 122

The varnishes Examples 121 and 122 are prepared by mixing a blend of resin comprising a glycidyl ether of bisphenol A having an EEW of about 180 and a polymer of hexamethoxy methylmelamine and bishpenol A, with a boric acid solution and a 2-methyl imidazole solution (both 10 percent in methanol). The resin is first blended with the boric acid solution for approximately 2 hours at room temperature. The homogeneous mixture is then mixed with 2-MI solution for approximately 2 hours prior to testing. The gel time and Tg are reported in Table XVIII.

Table XVIII

| Example | Boric acid phr | 2-MI phr | Gel time 170°C; sec | Tg °C min at 170°C |
|---|---|---|---|---|
| 121* | 0 | 0,2 | 176 | 133 |
| 127 | 0.6 | 0,2 | 270 | 129 |

* Example 121 is a comparative example

Examples 123 - 124

The varnishes of Examples 123-124 are prepared by blending and mixing the following components at room temperature for approximately one hour, a glycidyl polyether of 2,2-bis (4-hydroxyphenyl) propane having an epoxy equivalent weight of about 180, 100 parts methyltetrahydrophtalic anhydride, 80 parts, a boric acid solution (10 percent in methanol) and benzyldimethylamine (BDMA). The parts of boric acid and BDMA are reported in Table XIX. The gel time and Tg of cured films are measured. The gel time is measured by the following method. 20 g of the composition are weighed in a test tube, a metal wire is placed into the composition, it is attached to the gel timer, the tube is dipped in an oil bath at 140°C. When the metal wire cannot be moved anymore, the composition is gelled. The time from dipping the tube into the oil bath until the wire cannot move is measured as the gel time. The curing cycle for the films on which glass transition tests are run is as follows: 4 hours at 100°C and 12 hours at 140°C. The results are compiled in Table XIX.

Table XIX

| Example | Boric acid phr | BD MA phr | Gel time 140°C; sec | Tg°C |
|---|---|---|---|---|
| 123* | 0 | 0,5 | 302 | 110 |

* Example 123 is a comparative example

Table XIX (continued)

| Example | Boric acid phr | BD MA phr | Gel time 140°C; sec | Tg°C |
|---|---|---|---|---|
| 124 | 0,5 | 0,5 | 341 | 90 |

**Claims**

1. The use as a cure inhibitor for an epoxy resin composition of boric acid or maleic acid in an amount such as to inhibit curing of the epoxy resin during solvent removal.

2. The use according to Claim 1 wherein the cure inhibitor is boric acid.

3. The use according to any one of Claims 1 to 2 wherein the amount of boric acid is at least 0.013 mole per epoxide equivalent.

4. The use according to any one of the preceding claims wherein the cure inhibitor comprises a mixture of boric acid with at least one acid having a weak nucleophilic anion.

5. The use according to any one of the preceding Claims, wherein the amount of inhibitor employed is less than 2 parts of inhibitor per 100 parts of epoxy resin.

6. The use according to any one of the preceding claims wherein the epoxy resin composition further comprises an epoxy resin catalyst comprising an amine, a heterocyclic nitrogen compound, a phosphine, a sulfide, or an ammonium, phosphonium, arsonium, or sulfonium-containing compound, or a mixture of such compounds capable of accelerating the cure of the polyepoxide with a curing agent.

7. The use according to Claim 6 wherein the catalyst is present in a concentration of from 0.01 to 5.0 parts per hundred parts of polyepoxide.

8. An epoxy resin composition comprising

   A. a polyepoxide;
   B. a solvent; and
   C. a cure inhibitor, **characterised in that** the cure inhibitor comprises boric acid or maleic acid,
   provided that when the inhibitor is boric acid, it is present in an amount of at least 0.013 mole of inhibitor per epoxide equivalent of epoxy resin.

9. A composition according to Claim 8 wherein cure inhibitor is boric acid.

10. A composition according to preceding Claim 8 or Claim 9 wherein the cure inhibitor comprises a mixture of boric acid with at least one acid having a weak nucleophilic anion.

11. A composition according to any one of Claims 8 to 10, wherein the amount of inhibitor employed is less than 2 parts of inhibitor per 100 parts of epoxy resin.

12. A composition according to any one of Claims 8 to 11 wherein the epoxy resin composition further comprises an epoxy resin catalyst comprising an amine, a heterocyclic nitrogen compound, a phosphine, a sulfide, or an ammonium, phosphonium, arsonium, or sulfonium-containing compound, or a mixture of such compounds capable of accelerating the cure of the polyepoxide with a curing agent.

13. A composition according to Claim 12 wherein the catalyst is present in a concentration of from 0.01 to 5.0 parts per hundred parts of polyepoxide.

14. A latent catalyst composition suitable for addition to a polyepoxide for curing the composition whilst inhibiting curing of the composition during solvent removal at elevated temperature the latent catalyst composition comprising

i) a catalyst for the cure of a polyepoxide compound comprising an amine, heterocyclic nitrogen, phosphine, sulfide, ammonium, phosphonium, sulfonium, or arsonium-containing compound, or a mixture of two or more thereof, with
ii) boric acid or maleic acid.

**15.** A composition according to any one of Claims 12 to 14 wherein the catalyst is:-

a phosphonium compound selected from ethyltriphenyl phosphonium acetate, ethyltriphenyl phosphonium acetate acetic acid complex, tetrabutyl phosphonium acetate, tetrabutyl phosphonium acetate acetic acid complex, ethyltriphenyl phosphonium chloride, ethyl triphenyl phosphonium iodide, tetrabutyl phosphonium chloride, tetrabutyl phosphonium iodide and tetrabutylphosphonium hydroxide; an ammonium compound selected from tetrabutylammonium hydroxide, tetraethylammonium hydroxide, tetramethylammonium hydroxide, ethyltri(2-ethoxyethyl)ammonium hydroxide, triethyl(2-thioethylethyl)ammonium hydroxide, N-methyl-N-methylenemethanaminium acetate, N-methyl-N-methylenemethanaminium acetate acetic acid complex, N-methyl-N-methylenemethanaminium chloride, N-methyl-N-methylenemethanaminium iodide, N-methylpyridinium acetate, N-methylpyridinium acetate acetic acid complex, N-methylpyridinium chloride, N-methylpyridinium iodide, 1-ethyl-2,3-dimethylimidazolium acetate, 1-ethyl-2,3-dimethylimidazolium acetate acetic acid complex, 1-ethyl-2,3-dimethylimidazolium chloride, 1-ethyl-2,3-dimethylimidazolium iodide, N-methylquinolinium acetate, N-methylquinolinium acetate acetic acid complex, N-methylquinolinium chloride, N-methylquinolinium iodide, N-methyl-1,3,5-triazinium acetate, N-methyl-1,3,5-triazinium acetate acetic acid complex, N-methyl-1,3,5-triazinium chloride and N-methyl-1,3,5-triazinium iodide;

a non-heterocyclic amine selected from ethylamine, diethylamine, triethylamine, n-propylamine, di-n-propylamine, tri-n-propylamine, isopropylamine, diisopropylamine, triisopropylamine, butylamine, dibutylamine, tributylamine, methyldibutylamine or an heterocyclic amine selected from the group of imidazoles, imidazolidines, imidazolines, oxazoles, pyrroles, thiazoles, pyridines, pyrazines, morpholines, pyridazines, pyrimidines, pyrrolidines, pyrazoles, quinoxalines, quinazolines, phthalozines, quinolines, purines, indazoles, indoles, indolazines, phenazines, phenarsazines, phenothiazines, pyrrolines, indolines, piperidines and piperazines;

or any combination thereof; and, if present, the acid having a weak nucleophilic anion is fluoboric acid.

**16.** A composition according to Claim 15 wherein the catalyst is a tertiary amine-containing or a heterocyclic amine-containing compound; or a combination of two or more thereof.

**17.** A composition according to Claim 16 wherein the catalyst is 2-methyl imidazole; 2-ethyl, 4-methyl imidazole or 2-phenyl imidazole.

**18.** A composition according to any one of Claims 8 to 17 wherein the epoxy resin composition also comprises a curing agent, wherein the curing agent is an anhydride, a compound containing more than one aromatic hydroxyl, a polyamide, a polyamine, cyanamide, dicyanamide, a derivative of cyanamide or dicyanamide, a biphenol, a bisphenol, a halogenated bisphenol, an alkylated bisphenol, a trisphenol, a phenol-aldehyde resin, a halogenated phenol-aldehyde novolac resin, an alkylated phenol-aldehyde novolac resin, a phenol-hydroxybenzaldehyde resin, an alkylated phenol-hydroxybenzaldehyde resin, a hydrocarbon-phenol resin, hydrocarbon-halogenated phenol resin, a hydrocarbon-alkylated phenol resin, or any combination thereof.

**19.** The use according to any one of Claims 1 to 7 wherein the epoxy resin composition also comprises a curing agent, wherein the curing agent is an anhydride, a compound containing more than one aromatic hydroxyl, a polyamide, a polyamine, cyanamide, dicyanamide, a derivative of cyanamide or dicyanamide, a biphenol, a bisphenol, a halogenated bisphenol, an alkylated bisphenol, a trisphenol, a phenol-aldehyde resin, a halogenated phenol-aldehyde novolac resin, an alkylated phenol-aldehyde novolac resin, a phenol-hydroxybenzaldehyde resin, an alkylated phenol-hydroxybenzaldehyde resin, a hydrocarbon-phenol resin, hydrocarbon-halogenated phenol resin, a hydrocarbon-alkylated phenol resin, or any combination thereof.

**20.** A process for coating articles comprising

A) contacting an article with an epoxy resin composition containing a cure catalyst, which composition is a composition according to any one of Claims 8 to 18, wherein said composition is optionally in one or more miscible solvents.

B) optionally passing the coated article through a heated zone at a temperature sufficient to cause any solvents present to evaporate but below the temperature at which the polyepoxide undergoes significant curing; and
C) optionally exposing the coated article to conditions such that the polyepoxide undergoes at least partial curing.

**21.** The process of Claim 20 wherein the catalyst and inhibitor are present in the form of a preformed complex.

**22.** The process according to Claim 20 or Claim 21 wherein the epoxy resin composition comprises

i) 100 parts of a polyepoxide in a non polar solvent;
ii) 0.5 to 30 parts of curing agent per hundred parts of resin in a solvent;
iii) 0.2 to 2.0 parts of boric acid inhibitor per hundred parts of resin in a polar solvent; and
iv) 0.01 to 2.0 parts catalyst per hundred parts of resin;

wherein the ratio of inhibitor to catalyst is from 0.1:1 to 4.0:1.0.

**23.** A process according to Claim 22 which is a process for preparing a laminate wherein the article is a reinforcing material, which further comprises

C. forming pre-pregs of the coated reinforcing material;
D. contacting the pre-pregs of the coated reinforcing material in a desired arrangement; and
E. subjecting the contacted pre-pregs of coated reinforcing material to pressure at temperatures at which the polyepoxide undergoes significant cure wherein the pressure is sufficient to allow polyepoxide on each Pre-Preg to flow and mix with the polyepoxide or advanced epoxy resin on adjacent Pre-Pregs.

**24.** A composition comprising the partially cured reaction product of an epoxy resin composition according to any one of Claims 8 to 18, wherein the partially cured resin is capable of undergoing further curing.

**25.** The use according to any one of Claims 1 to 7 **characterized in that** the boric acid is contacted with one or more of the other components of the compositions in solution in a solvent which is a di- or trihydroxy substituted hydrocarbon.

**26.** The Process according to Claim 22 wherein the solvent is dimethylsulfoxide, N-methyl pyrrolidinone, 1,2 propanediol, diethylene glycol, ethylene glycol or glycerine.

## Patentansprüche

**1.** Verwendung als Härtungsinhibitor für eine Epoxyharzzusammensetzung von Borsäure oder Maleinsäure in einer solchen Menge, daß das Aushärten des Epoxyharzes während der Lösungsmittelentfernung inhibiert wird.

**2.** Verwendung nach Anspruch 1, bei welcher der Härtungsinhibitor Borsäure ist.

**3.** Verwendung nach einem der Ansprüche 1 bis 2, bei welcher die Menge von Borsäure wenigstens 0,013 Mol-% pro Epoxidäquivalent beträgt.

**4.** Verwendung nach einem der vorhergehenden Ansprüche, bei welcher der Härtungsinhibitor eine Mischung von Borsäure mit wenigstens einer Säure, die ein schwaches nucleophiles Anion besitzt, umfaßt.

**5.** Verwendung nach einem der vorhergehenden Ansprüche, bei welcher die Menge von verwendetem Inhibitor weniger als 2 Teile Inhibitor pro 100 Teile Epoxyharz beträgt.

**6.** Verwendung nach einem der vorhergehenden Ansprüche, bei welcher die Epoxyharzzusammensetzung weiter einen Epoxyharzkatalysator umfaßt, der ein Amin, eine heterocyclische Stickstoffverbindung, ein Phosphin, ein Sulfid oder eine Ammonium, Phosphonium, Arsonium oder Sulfonium enthaltende Verbindung oder eine Mischung solcher Verbindungen umfaßt, die zur Beschleunigung der Aushärtung des Polyepoxids mit einem Härter fähig sind.

7. Verwendung nach Anspruch 6, bei welcher der Katalysator in einer Konzentration von 0,01 bis 5,0 Teilen pro 100 Teile Polyepoxid vorhanden ist.

8. Epoxyharzzusammensetzung, umfassend:

A. ein Polyepoxid;
B. ein Lösungsmittel; und
C. einen Härtungsinhibitor,

**dadurch gekennzeichnet, daß** der Härtungsinhibitor Borsäure oder Maleinsäure umfaßt, vorausgesetzt, daß, falls der Inhibitor Borsäure ist, sie in einer Menge von wenigstens 0,013 Mol Inhibitor pro Epoxidäquivalent von Epoxyharz vorhanden ist.

9. Zusammensetzung nach Anspruch 8, bei welcher der Inhibitor Borsäure ist.

10. Zusammensetzung nach dem vorangehenden Anspruch 8 oder Anspruch 9, bei welcher der Härtungsinhibitor eine Mischung von Borsäure mit wenigstens einer Säure, die ein schwaches nucleophiles Anion besitzt, umfaßt.

11. Zusammensetzung nach einem der Ansprüche 8 bis 10, bei welcher die Menge von verwendetem Inhibitor weniger als 2 Teile Inhibitor pro 100 Teile Epoxyharz beträgt.

12. Zusammensetzung nach einem der Ansprüche 8 bis 11, bei welcher die Epoxyharzzusammensetzung weiter einen Epoxyharzkatalysator umfaßt, der ein Amin, eine heterocyclische Stickstoffverbindung, ein Phosphin, ein Sulfid oder eine Ammonium, Phosphonium, Arsonium oder Sulfonium enthaltende Verbindung oder eine Mischung solcher Verbindungen umfaßt, die zur Beschleunigung der Aushärtung des Polyepoxids mit einem Härter fähig sind.

13. Zusammensetzung nach Anspruch 12, bei welcher der Katalysator in einer Konzentration von 0,01 bis 5,0 Teilen pro 100 Teile Polyepoxid vorhanden ist.

14. Latente Katalysatorzusammensetzung, geeignet zum Zusatz zu einem Polyepoxid für die Aushärtung der Zusammensetzung, wobei das Aushärten der Zusammensetzung während Lösungsmittelentfernung bei erhöhter Temperatur inhibiert wird, wobei die latente Katalysatorzusammensetzung umfaßt:

i) einen Katalysator für das Aushärten einer Polyepoxidverbindung, umfassend ein Amin, heterocyclischen Stickstoff, Phosphin, Sulfid, Ammonium, Phosphonium, Arsonium oder Sulfonium enthaltende Verbindung oder eine Mischung von zwei oder mehreren hiervon, mit
ii) Borsäure oder Maleinsäure.

15. Zusammensetzung nach einem der Ansprüche 12 bis 14, bei welcher der Katalysator ist:

eine Phosphoniumverbindung, ausgewählt aus Ethyltriphosphoniumacetat, Ethyltriphosphoniumacetat-Essigsäurekomplex, Tetrabutylphosphoniumacetat, Tetrabutylphosphoniumacetat-Essigsäurekomplex, Ethyltriphosphoniumchlorid, Ethyltriphosphoniumjodid, Tetrabutylphosphoniumchlorid, Tetrabutylphosphoniumjodid und Tetrabutylphosphoniumhydroxid;
eine Ammoniumverbindung, ausgewählt aus Tetrabutylammoniumhydroxid, Tetraethylammoniumhydroxid, Tetramethylammoniumhydroxid, Ethyltri(2-ethoxyethyl)ammoniumhydroxid, Triethyl(2-thioethylethyl)ammoniumhydroxid, N-Methyl-N-methylenmethanaminiumacetat, N-Methyl-N-methylenmethanaminiumacetat-Essigsäurekomplex, N-Methyl-N-methylenmethanaminiumchlorid, N-Methyl-N-methylenmethanaminiumjodid, N-Methylpyridiniumacetat, N-Methylpyridiniumacetat-Essigsäurekomplex, N-Methylpyridiniumchlorid, N-Methylpyridiniumjodid, 1-Ethyl-2,3-dimethylimidazoliumacetat, 1-Ethyl-2,3-dimethylimidazoliumacetat-Essigsäurekomplex, l-Ethyl-2,3-dimethylimidazoliumchlorid, 1-Ethyl-2,3-dimethylimidazoliumjodid, N-Methylchinoliniumacetat, N-Methylchinoliniumacetat-Essigsäurekomplex, N-Methylchinoliniumchlorid, N-Methylchinoliniumjodid, N-Methyl-1,3,5-triaziniumacetat, N-Methyl-1,3,5-triaziniumacetat-Essigsäurekomplex, N-Methyl-1,3,5-triaziniumchlorid und N-Methyl-1,3,5-triaziniumjodid;
ein nicht-heterocyclisches Amin, ausgewählt aus Ethylamin, Diethylamin, Triethylamin, n-Propylamin, Di-n-propylamin, Tri-n-propylamin, Isopropylamin, Diisopropylamin, Triisopropylamin, Butylamin, Dibutylamin, Tributylamin, Methyldibutylamin, oder
ein heterocyclisches Amin, ausgewählt aus der Gruppe von Imidazolen, Imidazolidinen, Imidazolinen, Oxazolen, Pyrrolen, Thiazolen, Pyridinen, Pyrazinen, Morpholinen, Pyridazinen, Pyrimidinen, Pyrrolidinen, Pyrazolen, Chinoxalinen, Chinazolinen, Phthalozinen, Chinolinen, Purinen, Indazolen, Indolen, Indolazinen, Phenazinen, Phenarsazinen, Phenothiazinen, Pyrrolinen, Indolinen, Piperidinen und Piperazinen; oder einer beliebigen Kombination hiervon, und, falls vorhanden, die Säure mit einem schwachen nucleophilen Anion Fluoborsäure ist.

**16.** Zusammensetzung nach Anspruch 15, bei welcher der Katalysator eine tertiäres Amin enthaltende oder ein heterocyclisches Amin enthaltende Verbindung oder eine Kombination von zwei oder mehreren hiervon ist.

**17.** Zusammensetzung nach Anspruch 16, bei welcher der Katalysator 2-Methylimidazol; 2-Ethyl-, 4-Methylimidazol oder 2-Phenylimidazol ist.

**18.** Zusammensetzung nach einem der Ansprüche 8 bis 17, bei welcher die Epoxyharzzusammensetzung ebenfalls einen Härter enthält, wobei der Härter ein Anhydrid, eine mehr als ein aromatisches Hydroxyl enthaltende Verbindung, ein Polyamid, ein Polyamin, Cyanamid, Dicyanamid, ein Derivat von Cyanamid oder Dicyanamid, ein Biphenol, ein Bisphenol, ein halogeniertes Bisphenol, ein alkyliertes Bisphenol, ein Trisphenol, ein Phenol-Aldehydharz, ein halogeniertes Phenol-Aldehydnovolakharz, ein alkyliertes Phenol-Aldehydnovolakharz, ein Phenol-Hydroxybenzaldehydharz, ein alkyliertes Phenol-Hydroxybenzaldehydharz, ein Kohlenwasserstoff-Phenolharz, ein Kohlenwasserstoff-halogeniertes-Phenolharz, ein Kohlenwasserstoff-alkyliertes-Phenolharz oder eine beliebige Kombination hiervon ist.

**19.** Verwendung nach einem der Ansprüche 1 bis 7, bei welcher die Epoxyharzzusammensetzung ebenfalls einen Härter enthält, wobei der Härter ein Anhydrid, eine mehr als ein aromatisches Hydroxyl enthaltende Verbindung, ein Polyamid, ein Polyamin, Cyanamid, Dicyanamid, ein Derivat von Cyanamid oder Dicyanamid, ein Biphenol, ein Bisphenol, ein halogeniertes Bisphenol, ein alkyliertes Bisphenol, ein Trisphenol, ein Phenol-Aldehydharz, ein halogeniertes Phenol-Aldehydnovolakharz, ein alkyliertes Phenol-Aldehydnovolakharz, ein Phenol-Hydroxybenzaldehydharz, ein alkyliertes Phenol-Hydroxybenzaldehydharz, ein Kohlenwasserstoff-Phenolharz, ein Kohlenwasserstoff-halogeniertes-Phenolharz, ein Kohlenwasserstoff-alkyliertes-Phenolharz oder eine beliebige Kombination hiervon ist.

**20.** Verfahren zum Beschichten von Gegenständen, umfassend:

A) Inkontaktbringen eines Gegenstandes mit einer Epoxyharzzusammensetzung, die einen Aushärtkatalysator enthält, wobei diese Zusammensetzung eine Zusammensetzung nach einem der Ansprüche 8 bis 18 ist, worin diese Zusammensetzung wahlweise in einem oder mehreren mischbaren Lösungsmitteln vorliegt,
B) wahlweise Durchführen des beschichteten Gegenstandes durch eine erhitzte Zone bei einer ausreichenden Temperatur, um das Verdampfen irgendwelcher vorliegenden Lösungsmittel zu bewirken, jedoch unterhalb der Temperatur, bei welcher das Polyepoxid signifikantes Aushärten durchmacht; und
C) wahlweise Exponieren des beschichteten Gegenstandes solchen Bedingungen, daß das Polyepoxid wenigstens partielles Aushärten durchmacht.

**21.** Verfahren nach Anspruch 20, bei welchem der Katalysator und Inhibitor in Form eines vorgebildeten Komplexes vorhanden sind.

**22.** Verfahren nach Anspruch 20 oder Anspruch 21, bei welchem die Epoxyharzzusammensetzung umfaßt:

i) 100 Teile Polyepoxid in einem nicht-polaren Lösungsmittel;
ii) 0,5 bis 30 Teile Härter pro 100 Teile Harz in einem Lösungsmittel;
iii) 0,2 bis 2,0 Teile Borsäureinhibitor pro 100 Teile Harz in einem Lösungsmittel; und
iv) 0,01 bis 2,0 Teile Katalysator pro 100 Teile Harz;

bei welchem das Verhältnis von Inhibitor zu Katalysator von 0, 1:1 bis 4,0:1,0 beträgt.

**23.** Verfahren nach Anspruch 23, das ein Verfahren zum Herstellen eines Laminates ist, bei welchem der Gegenstand ein verstärkendes Material ist, welches weiter umfaßt:

C. Bilden von Prepregs des beschichteten verstärkenden Materials;
D. Inkontaktbringen der Prepregs des beschichteten verstärkenden Materials in einer gewünschten Anordnung; und
E. Unterziehen der in Kontakt gebrachten Prepregs aus beschichtetem verstärkendem Material Druck bei Temperaturen, bei denen das Polyepoxid signifikantes Aushärten durchmacht, wobei der Druck ausreichend ist, damit Fließen und Mischen von Polyepoxid auf jedem Prepreg mit dem Polyepoxid oder verlängertem Epoxyharz auf benachbarten Prepregs ermöglicht wird.

**24.** Zusammensetzung, umfassend das partiell ausgehärtete Reaktionsprodukt einer Epoxyharzzusammensetzung entsprechend einem der Ansprüche 8 bis 18, bei welcher das partiell ausgehärtete Harz in der Lage ist, weiteres Aushärten durchzumachen.

**25.** Verwendung nach einem der Ansprüche 1 bis 7, **dadurch gekennzeichnet, daß** die Borsäure mit einer oder mehreren der anderen Komponenten der Zusammensetzungen in Lösung in einem Lösungsmittel, welches ein di- oder trihydroxy-substituierter Kohlenwasserstoff ist, in Kontakt gebracht wird.

**26.** Verfahren nach Anspruch 22, bei welchem das Lösungsmittel Dimethylsulfoxid, N-Methylpyrrolidinon, 1,2-Propandiol, Diethylenglykol, Ethylenglykol oder Glycerin ist.

## Revendications

**1.** Emploi, en tant qu'inhibiteur de durcissement pour une composition de résine époxyde, d'acide borique ou d'acide maléique en une quantité appropriée pour inhiber le durcissement de la résine époxyde au cours de l'élimination du solvant.

**2.** Emploi conforme à la revendication 1, dans lequel l'inhibiteur de durcissement est de l'acide borique.

**3.** Emploi conforme à l'une des revendications 1 et 2, dans lequel la quantité d'acide borique vaut au moins 0,013 mole par équivalent époxyde.

**4.** Emploi conforme à l'une des revendications précédentes, dans lequel l'inhibiteur de durcissement comprend un mélange d'acide borique et d'au moins un acide dont l'anion est un nucléophile faible.

**5.** Emploi conforme à l'une des revendications précédentes, dans lequel la quantité d'inhibiteur employée vaut moins de 2 parties d'inhibiteur pour 100 parties de résine époxyde.

**6.** Emploi conforme à l'une des revendications précédentes, dans lequel la composition de résine époxyde comporte en outre un catalyseur pour résine époxyde, lequel comprend une amine, un composé hétérocyclique azoté, une phosphine, un sulfure, ou un composé d'ammonium, de phosphonium, d'arsonium ou de sulfonium, ou un mélange de tels composés, capable d'accélérer le durcissement du polyépoxyde par un durcisseur.

**7.** Emploi conforme à la revendication 6, dans lequel le catalyseur se trouve présent en une proportion de 0.01 à 5,0 parties pour 100 parties de polyépoxyde.

**8.** Composition de résine époxyde comprenant :

i) un polyépoxyde,
ii) un solvant,
iii) et un inhibiteur de durcissement,

**caractérisée en ce que** l'inhibiteur de durcissement comprend de l'acide borique ou de l'acide maléique,
sous réserve que, si l'inhibiteur est de l'acide borique, il se trouve présent en une quantité d'au moins 0,013 mole d'inhibiteur par équivalent époxyde de la résine époxyde.

**9.** Composition conforme à la revendication 8, dans laquelle l'inhibiteur de durcissement est de l'acide borique.

**10.** Composition conforme à la revendication 8 ou 9, dans laquelle l'inhibiteur de durcissement comprend un mélange d'acide borique et d'au moins un acide dont l'anion est un nucléophile faible.

**11.** Composition conforme à l'une des revendications 8 à 10, dans laquelle la quantité d'inhibiteur employée vaut moins de 2 parties d'inhibiteur pour 100 parties de résine époxyde.

**12.** Composition conforme à l'une des revendications 8 à 11, dans laquelle la composition de résine époxyde comporte en outre un catalyseur pour résine époxyde, lequel comprend une amine, un composé hétérocyclique azoté, une phosphine, un sulfure, ou un composé d'ammonium, de phosphonium, d'arsonium ou de sulfonium, ou un mélange de tels composés, capable d'accélérer le durcissement du polyépoxyde par un durcisseur.

**13.** Composition conforme à la revendication 12, dans laquelle le catalyseur se trouve présent en une proportion de 0,01 à 5,0 parties pour 100 parties de polyépoxyde.

**14.** Composition de catalyseur latent, appropriée pour être ajoutée à un polyépoxyde afin de faire durcir la composition tout en inhibant le durcissement de la composition pendant l'élimination du solvant à haute température, laquelle composition de catalyseur latent comporte :

i) un catalyseur de durcissement de polyépoxyde, qui comprend une amine, un composé hétérocyclique azoté, une phosphine, un sulfure, ou un com-posé d'ammonium, de phosphonium, d'arsonium ou de sulfonium, ou un mélange de deux de ces composés ou plus,
ii) et de l'acide borique ou de l'acide maléique.

**15.** Composition conforme à l'une des revendications 12 à 14, dans laquelle le catalyseur est :

A) un composé de phosphonium, choisi parmi l'acétate d'éthyl-triphénylphosphonium, un complexe d'acide acétique et d'acétate d'éthyl-triphénylphosphonium, l'acétate de tétrabutylphosphonium, un complexe d'acide acétique et d'acétate de tétrabutylphosphonium, le chlorure d'éthyl-triphénylphosphonium, l'iodure d'éthyl-triphénylphosphonium, le chlorure de tétrabutylphosphonium, l'iodure de tétrabutylphosphonium, et l'hydroxyde de tétrabutylphosphonium ;
B) un composé d'ammonium choisi parmi l'hydroxyde de tétrabutylammonium, l'hydroxyde de tétraéthylammonium, l'hydroxyde de tétraméthylammonium, l'hydroxyde d'éthyl-tris(2-éthoxyéthyl)ammonium, l'hydroxyde de triéthyl-(2-thioéthyléthyl)ammonium, l'acétate de N-méthyl-N-méthylène-méthanaminium, un complexe d'acide acétique et d'acétate de N-méthyl-N-méthylène-méthanaminium, le chlorure de N-méthyl-N-méthylène-méthanaminium, l'iodure de N-méthyl-N-méthylène-méthanaminium, l'acétate de N-méthyl-pyridinium, un complexe d'acide acétique et d'acétate de N-méthyl-pyridinium, le chlorure de N-méthyl-pyridinium, l'iodure de N-méthyl-pyridinium, l'acétate de 1-éthyl-2,3-diméthyl-imidazolium, un complexe d'acide acétique et d'acétate de 1-éthyl-2,3-diméthyl-imidazolium, le chlorure de 1-éthyl-2,3-diméthyl-imidazolium, l'iodure de 1-éthyl-2,3-diméthyl-imidazolium, l'acétate de N-méthyl-quinoléinium, un complexe d'acide acétique et d'acétate de N-méthyl-quinoléinium, le chlorure de N-méthyl-quinoléinium, l'iodure de N-méthyl-quinoléinium, l'acétate de N-méthyl-1,3,5-triazinium, un complexe d'acide acétique et d'acétate de N-méthyl-1,3,5-triazinium, le chlorure de N-méthyl-1,3,5-triazinium, et l'iodure de N-méthyl-1,3,5-triazinium ;
C) un amine non-hétérocyclique, choisie parmi les éthylamine, diéthylamine, triéthylamine, n-propylamine, di-n-propylamine, tri-n-propylamine, isopropylamine, diisopropylamine, triisopropylamine, butylamine, dibutylamine, tributylamine et méthyl-dibutylamine, ou une amine hétérocyclique, choisie parmi les imidazoles, imidazolidines, imidazolines, oxazoles, pyrroles, thiazoles, pyridines, pyrazines, morpholines, pyridazines, pyrimidines, pyrrolidines, pyrazoles, quinoxalines, quinazolines, phtalazines, quinoléines, purines, indazoles, indoles, indolazines, phénazines, phénarsazines, phénothiazines, pyrrolines, indolines, pipéridines et pipérazines ;

ou une combinaison quelconque de tels composés, et dans laquelle l'acide dont l'anion est un nucléophile faible, s'il y en a un, est de l'acide borofluorhydrique.

**16.** Composition conforme à la revendication 15, dans laquelle le catalyseur est un composé à fonction amine tertiaire ou amine hétérocyclique, ou une combinaison de deux composés de ce type ou plus.

**17.** Composition conforme à la revendication 16, dans laquelle le catalyseur est du 2-méthyl-imidazole, du 2-éthyl-4-méthyl-imidazole ou du 2-phényl-imidazole.

**18.** Composition conforme à l'une des revendications 8 à 17, dans laquelle la composition de résine époxyde contient aussi un agent durcisseur qui est un anhydride, un composé comportant plus d'un groupe hydroxyle aromatique,

un polyamide, une polyamine, du cyanamide, du dicyanamide, un dérivé du cyanamide ou du dicyanamide, un diphénol, un bisphénol, un bisphénol halogéné, un bisphénol alkylé, un trisphénol, une résine phénol-aldéhyde, unc résine phénol-aldéhyde de type novolaque halogénée, une résinc phénol-aldéhyde de type novolaque alkylée, une résine phénol-hydroxybenzaldéhyde, une résine phénol-hydroxybenzaldéhyde alkylée, une résine hydrocarbure-phénol, une résine hydrocarbure-(phénol halogéné), ou une résine hydrocarbure-(phénol alkylé), ou encore une combinaison de tels composés.

**19.** Emploi conforme à l'une des revendications 1 à 7, dans lequel la composition de résine époxyde contient aussi un agent durcisseur qui est un anhydride, un composé comportant plus d'un groupe hydroxyle aromatique, un polyamide, une polyamine, du cyanamide, du dicyanamide, un dérivé du cyanamide ou du dicyanamide, un diphénol, un bisphénol, un bisphénol halogéné, un bisphénol alkylé, un trisphénol, une résine phénol-aldéhyde, une résine phénol-aldéhyde de type novolaque halogénée, une résine phénol-aldéhyde de type novolaque alkylée, une résine phénol-hydroxybenzaldéhyde, une résine phénol-hydroxybenzaldéhyde alkylée, une résine hydrocarbure-phénol, une résine hydrocarbure-(phénol halogéné), ou une résine hydrocarbure-(phénol alkylé), ou encore une combinaison de tels composés.

**20.** Procédé de revêtement de pièces, qui comporte :

A) le fait de mettre une pièce en contact avec une composition de résine époxyde contenant un catalyseur de durcissement, laquelle composition est une composition conforme à l'une des revendications 8 à 18 et se trouve éventuellement dans un ou plusieurs solvants miscibles ;
B) éventuellement, le fait de faire passer la pièce revêtue dans une zone chauffée à une température suffisante pour provoquer l'évaporation de tout solvant présent, mais inférieure à la température à laquelle se produit un durcissement significatif du polyépoxyde ;
C) et éventuellement, le fait de mettre la pièce revêtue dans des conditions de nature à provoquer un durcissement au moins partiel du polyépoxyde.

**21.** Procédé conforme à la revendication 20, dans lequel le catalyseur et l'inhibiteur se trouvent présents sous la forme d'un complexe formé au préalable.

**22.** Procédé conforme à la revendication 20 ou 21, dans lequel la composition de résine époxyde contient :

i) 100 parties d'un polyépoxyde, dans un solvant non polaire,
ii) 0,5 à 30 parties d'agent durcisseur, pour 100 parties de résine, dans un solvant,
iii) 0,2 à 2,0 parties d'acide borique en tant qu'inhibiteur, pour 100 parties de résine, dans un solvant polaire,
iv) et 0,01 à 2,0 parties de catalyseur, pour 100 parties de résine,

le rapport de l'inhibiteur au catalyseur valant de 0,1/1 à 4,0/1,0.

**23.** Procédé, conforme à la revendication 22, de fabrication de stratifiés, dans lequel la pièce est un matériau de renfort et qui comporte en outre :

C. le fait de préparer des pré-imprégnés de matériau de renfort revêtu ;
D. le fait de mettre en contact ces pré-imprégnés de matériau de renfort revêtu, dans la disposition voulue ;
E. et le fait de placer sous pression les pré-imprégnés de matériau de renfort revêtu mis en contact, à une température à laquelle se produit un durcissement significatif du polyépoxyde, la pression exercée étant suffisante pour que le polyépoxyde de chaque pré-imprégné puisse couler et se mêler au polyépoxyde ou à la résine époxyde prépolymérisée des pré-imprégnés adjacents.

**24.** Composition qui comprend le produit de réaction, partiellement durci, d'une composition de résine époxyde conforme à l'une des revendications 8 à 18, et dans laquelle la résine partiellement durcie peut encore durcir davantage.

**25.** Emploi conforme à l'une des revendications 1 à 7, caractérisé cn ce que l'acide borique est mis en contact avec un ou plusieurs des autres composants de la composition qui se trouvent en solution dans un solvant qui est un hydrocarbure dihydroxylé ou trihydroxylé.

**26.** Procédé conforme à la revendication 22, dans lequel le solvant est du diméthylsulfoxyde, de la N-méthyl-pyrrolidinone, du 1,2-propane-diol, du diéthylèneglycol, de l'éthylèneglycol ou du glycérol.